# EUROPEAN PATENT APPLICATION

(11) **EP 1 492 159 A1**
(43) Date of publication of application: **29.12.2004**
(21) Application number: 03708660.0
(22) Date of filing: 18.03.2003
(51) Int. Cl.: H01L 21/205, H01L 21/31, C23C 16/44

(54) **METHOD OF DEPOSITING CVD THIN FILM**

(30) Priority: 18.03.2002 JP 2002075258
(71) Applicant: KABUSHIKI KAISHA WATANABE SHOKO, Chuo-ku, Tokyo 103-0022 (JP)
(72) Inventor: YAMOTO, Hisayoshi, c/o WACOM ELECTRIC CO., LTD, Tokyo 103-0022 (JP); FUKAGAWA,Mitsuru c/o WACOM ELECTRIC CO., LTD, Tokyo 103-0022 (JP)
(74) Representative: Dr. Weitzel & Partner
(86) International application number: PCT/JP2003/003270
(87) International publication number: WO 2003/079421

(57) **Abstract**

It is an object of the present invention to provide a CVD thin film deposition method which can be used for a long time without producing cloggings or the like and can stably supply raw materials to a reaction portion. In the CVD thin film deposition method which forms a predetermined CVD thin film by passing a CVD raw material solution and a gas to a CVD chamber through a vaporizer for an appropriate time, the gas from a vaporizer outlet is switched to an exhaust side and only a solvent which can dissolve attachments adhering to the vaporizer is caused to flow through the vaporizer when the predetermined time passed.

## Description

### Technical Field

The present invention relates to a method for depositing a CVD thin film such as an MOCVD.

### Background Art

A problem in development of a DRAM is a storage capacitance involved by realization of minuteness. Considering software errors or the like, a capacitance that is substantially the same as that in a preceding generation is demanded, and hence any measure is required. As such a measure, a cell structure up to 1 M is a planar structure, but a three-dimensional structure called a stack structure or a trench structure is adopted from 4 M in order to increase a capacitor area. Further, as a dielectric film, there has been adopted a film obtained by laminating a thermal oxide film and a CVD nitride film on poly-Si from a thermal oxide film of a substrate Si (this laminated film is generally referred to as an ON film). In a 16M DRAM, a three-dimensional type which utilizes side surfaces in the stack type, a fin type which also utilizes a back side of a plate, or the like has been incorporated in order to increase an area contributing to a capacity.

In such a three-dimensional structure, however, an increase in the number of work stages and an increase in the number of steps due to complexity of a process and a reduction in yield due to an increase in steps are regarded as problems, and it is considered that realization with 256M bits or above is difficult. Therefore, as one way of further increasing a degree of integration without changing a structure'of a current DRAM, a method for switching a dielectric of a capacitance to that having a high dielectric constant has been planed out. Further, as a dielectric film with a high dielectric constant, a thin film of a monometal paraelectric oxide with a high dielectric constant such as Ta₂O₅, Y₂O₃, HfO₂ and others has first attracted attention. As to a relative dielectric constant, Ta₂O₅ has 28, Y₂O₃ has 16, and HfO₂ has approximately 24, which is four- to seven-fold of that of SiO₂.

However, application to 256M or higher DRAM requires a three-dimensional capacitor structure. As materials which have a higher specific dielectric constant than those of the above-described oxides and are expected to be applied to DRAMs, the following three types are considered as strong candidates:

(BaₓSr₁₋ₓ)TiO₃;

Pb(Zr_{y}Ti_{1-y})O₃;

and

(PbₐL₁₋ₐ) (Zr_{b}Ti_{1-b})O₃

Further, a Bi-based laminated structure having a crystal structure similar to that of a superconductive material has a high dielectric constant and self-polarization with ferroelectric characteristics and is superior as a non-volatile memory, and hence it attracts great attention in recent years.

In general, formation of an SrBi₂TaO₉ ferroelectric thin film is carried out by an MOCVD (organic metal vapor growth) method that is practical with great expectations.

Materials of the ferroelectric thin film are three types of organic metal complex Sr(DPM)₂, Bi(C₆H₅)₃ and Ta(OC₂H₅)₅, and these materials are respectively dissolved in THF (tetrahydrofuran), hexane or any other solvent and used as raw material solutions. Sr(Ta(OEₜ)6)₂ or Bi(OtAm)₃ is also solved in hexane or any other solvent, and used as a raw material solution. It is to be noted that DPM stands for dipivaloylmethane.

Table 1 shows respective material characteristics.

**(Table 1)**

| Characteristics of raw materials of the ferroelectric thin film | | |
|---|---|---|
| | Boiling point (°C)/pressure (mmHg) | Fusing point (°C) |
| Sr(DPM)₂ | 231/0.1 | 210 |
| Bi(C₆H₅)₃ | 130/0.1 | 80 |
| Ta(OC₂H₅)₅ | 118/0.1 | 22 |
| THF | 67 | -109 |
| Sr(Ta(OEt)₆)₂ | 176/0.1 | 130 |
| Bi(OtAm)₃ | 87/0.1 | 90 |

An apparatus used in the MOCVD method comprises a reaction portion which causes a gas phase reaction and a surface reaction of an SrBi₂TaO₉ thin film raw material and forms a film, and a supply portion which supplies the SrBi₂TaO₉ thin film raw material and an oxidizer to the reaction portion.

Furthermore, the supply portion is provided with a vaporizer which vaporizes the thin film raw material.

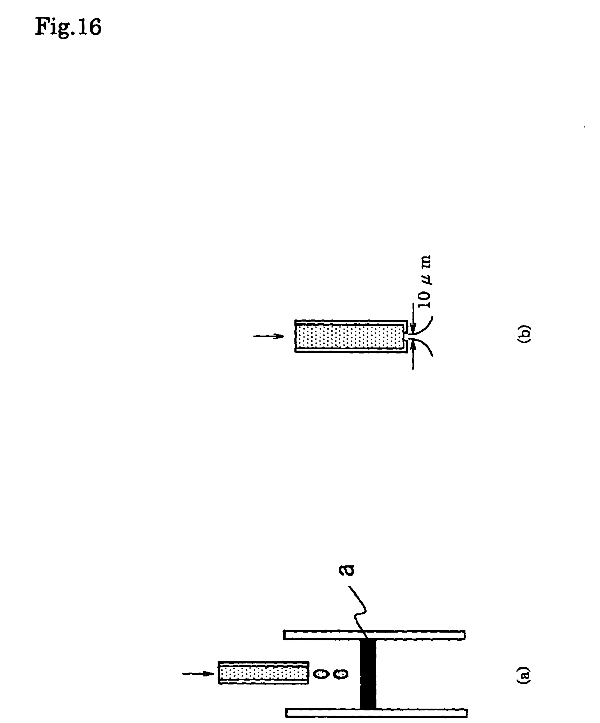

Conventionally, as a technique concerning the vaporizer, each method shown in FIG. 16 is known. A method shown in FIG. 16(a) is referred to as a metal filter method which performs vaporization by leading a raw material solution heated to a predetermined temperature to a metal filter which is used to increase a contact area between a gas existing in a surrounding environment and an SrBi₂TaO₉ ferroelectric thin film raw material solution.

In this technique, however, since the metal filter is clogged due to vaporization for several hours, there is a problem that this technique cannot withstand a use for a long time. The present inventor has surmised that this problem occurs since the solutions are heated and vaporization starts from a part with a low vaporization temperature.

FIG. 16(b) shows a technique which discharges a raw material solution from a pore of 10 µm by applying a pressure of 30 kgf/cm² to the raw material solution, and vaporizes the raw material solution by utilization of expansion.

In this technique, however, the pore is clogged due to a use for several hours, and there is likewise a problem that this technique cannot withstand a use for a long time.

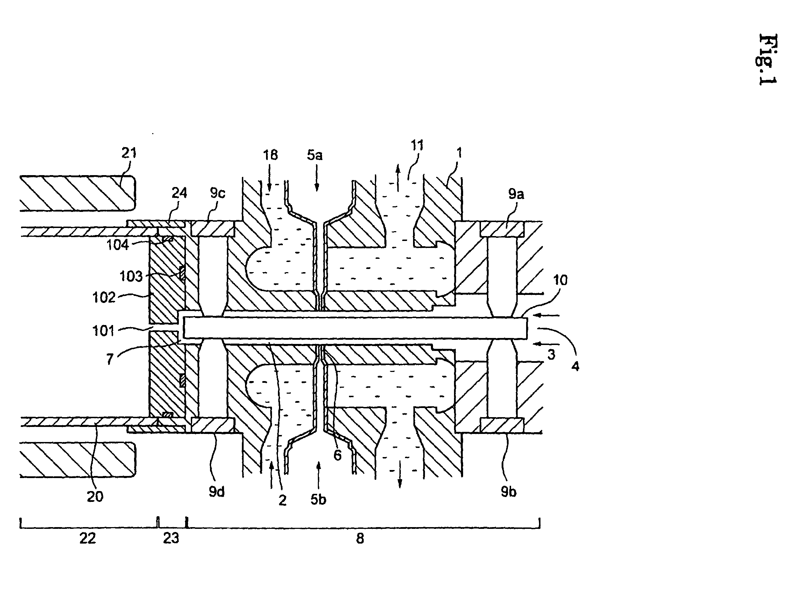

Moreover, when a raw material solution is a mixed solution using a plurality of organic metal complexes, e.g., a mixed solution of Sr(DPM)₂/THF and Bi(C₆H₅)₃/THF and Ta(OC₂H₅)₅/THF and, when this mixed solution is vaporized by heating, a solvent with a highest steam pressure (THF in this example) is vaporized at first, and there occurs a problem that the raw material cannot be stably supplied to the reaction portion since each organic metal complex precipitation-adheres to a heated surface. In all of these methods shown in FIG. 1, a heat quantity which can cause evaporation or changes of the solution is applied in a liquid or mist state.

Additionally, in the MOCVD, an evaporated gas in which a raw material solution is evenly dispersed must be obtained in order to acquire a film superior in evenness. However, the prior art cannot accept this demand.

In order to accept such a demand, the present inventor additionally provides the following technique.

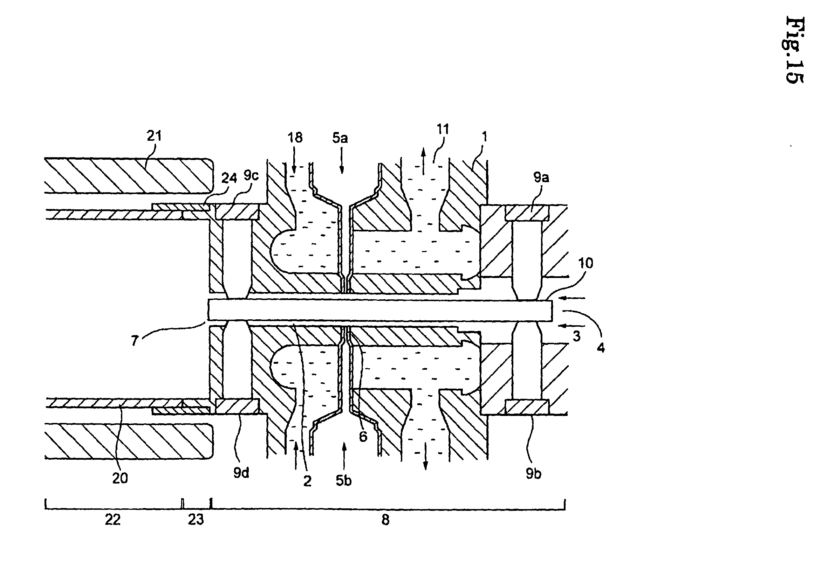

That is, as shown in FIG. 15,
there is provided an MOCVD vaporizer comprising:
(1) a dispersion portion having a gas passage formed therein, a gas introduction opening used to introduce a pressurized carrier gas to the gas passage, means for supplying a raw material solution to the gas passage, a gas outlet from which the carrier gas including the raw material solution is supplied to a vaporization portion, means for cooling the gas passage, and a radiant heat preventing jet portion cooled in such a manner that a thermal energy is not applied to the raw material gas in the dispersion portion due to radiant heat from the vaporization portion;
(2) a vaporization portion which has a vaporization tube having one end connected with a reaction tube of an MOCVD apparatus and the other end connected with the gas outlet, and heating means for heating the vaporization tube, the vaporization portion heating and vaporizing the carrier gas including the raw material solution supplied from the dispersion portion; and a radiant heat preventing jet portion cooled in such a manner that a thermal energy is not applied to the raw material gas in the dispersion portion due to radiant heat from the vaporization portion.

This technique corresponds to the MOCVD vaporizer which reduces cloggings as compared with the prior art, can be used for a long time and stably apply raw materials to the reaction portion.

Further, according to this technique, an introduction opening of preheated oxygen is provided on the downstream side of the vaporization portion.

However, even if this technique is used, precipitation of a crystal is observed in the gas passage, and clogging is generated in some cases.

Furthermore, a large quantity of carbon (30 to 40 at%) is contained in the formed film. In order to remove this carbon, annealing (example: 800°C, 60 minutes, oxygen atmosphere) must be carried out at a high temperature after film formation.

Moreover, when film formation is carried out, a composition ratio becomes largely uneven.

It is an object of the present invention to provide a method for depositing a CVD thin film which can be used for a long time without generating clogging or the like.

### Disclosure of Invention

According to the present invention, there is provided a CVD thin film deposition method which forms a predetermined CVD thin film by passing a CVD raw material solution and a gas to a CVD chamber for an appropriate time through a vaporizer, wherein the gas from a vaporizer outlet is switched to an exhaust side and only a solvent which can dissolve attachments adhering to the vaporizer (which will be referred to as a "cleaning solvent" hereinafter) is caused to flow through the vaporizer when the predetermined time passed.

According to the present invention, there is provided a CVD thin film deposition method which forms a predetermined CVD thin film by passing a CVD raw material solution and a gas to a CVD chamber for an appropriate time through a vaporizer, wherein the gas from a vaporizer outlet is switched to an exhaust side and only a solvent which can dissolve attachments adhering to the vaporizer is caused to flow through the vaporizer to clean the vaporizer when the predetermined time passed, and
an operation of taking out a substrate on which a predetermined thin film is formed and setting a new substrate in the CVD chamber is performed in the CVD chamber simultaneously with the cleaning.

According to the present invention, there is provided a CVD thin film deposition method which forms a predetermined CVD thin film by passing a CVD raw material solution and a gas to a CVD chamber for an appropriate time through a vaporizer,
wherein the gas from a vaporizer outlet is switched to an exhaust side in order to interrupt deposition of a thin film and a type and a flow quantity of the CVD raw material solution are changed to those of a new CVD raw material solution when the predetermined time passed, and
the new CVD raw material solution and the gas are passed to the CVD chamber through the vaporizer for an appropriate time and deposition of a thin film is restarted in order to form two types of CVD thin films having different compositions when a sum (capacity) of flow quantities of the new CVD raw material solution exceeds onefold or twofold of a pipe arrangement capacity from a CVD raw material solution switching valve to the vaporizer.

According to the present invention, there is provided a CVD thin film deposition method which forms a predetermined CVD thin film by passing a CVD raw material solution and a gas to a CVD chamber for an appropriate time through a vaporizer,
wherein the CVD thin film deposition method continuously forms two or more types of CVD thin films by repeating:
a first operation of switching the gas from a vaporizer outlet to an exhaust side in order to interrupt deposition of a thin film and changing a type and a flow quantity of the CVD raw material solution to those of a new CVD raw material solution when the predetermined time passed; and
a second operation of passing the new CVD raw material solution and the gas to the CVD chamber through the vaporizer for an appropriate time and restarting deposition of a thin film in order to form a second CVD thin film having a different composition when a sum (capacity) of flow quantities of the new CVD raw material solution exceeds onefold or twofold of a pipe arrangement capacity from a CVD raw material solution switching valve to the vaporizer.

According to the present invention, there is provided a CVD thin film deposition method which forms a predetermined CVD thin film by passing a CVD raw material solution and a gas to a CVD chamber for an appropriate time through a vaporizer,
wherein the gas from a vaporizer outlet is switched to an exhaust side in order to interrupt deposition of a thin film, a type and a flow quantity of the CVD raw material solution are changed to those of a new CVD raw material solution and a substrate temperature/reaction pressure is changed when the predetermined time passed, and
two or more types of CVD thin films are continuously formed by repeating a second operation of passing the new CVD raw material solution and the gas to the CVD chamber through the vaporizer for an appropriate time and restarting deposition of a thin film in order to form a second CVD thin film having a different composition when a sum (capacity) of flow quantities of the new CVD raw material solution exceeds onefold or twofold of a pipe arrangement capacity from a CVD raw material solution switching valve to the vaporizer.

It is preferable that the cleaning solvent is a solvent of a CVD raw material. Cleaning can be effected by just switching a valve without preparing a new cleaning solvent.

It is preferable that the cleaning solvent is one or more of hexane, benzene, toluene, octane and decane. These chemicals can readily prevent the vaporizer in the MOCVD from being clogged.

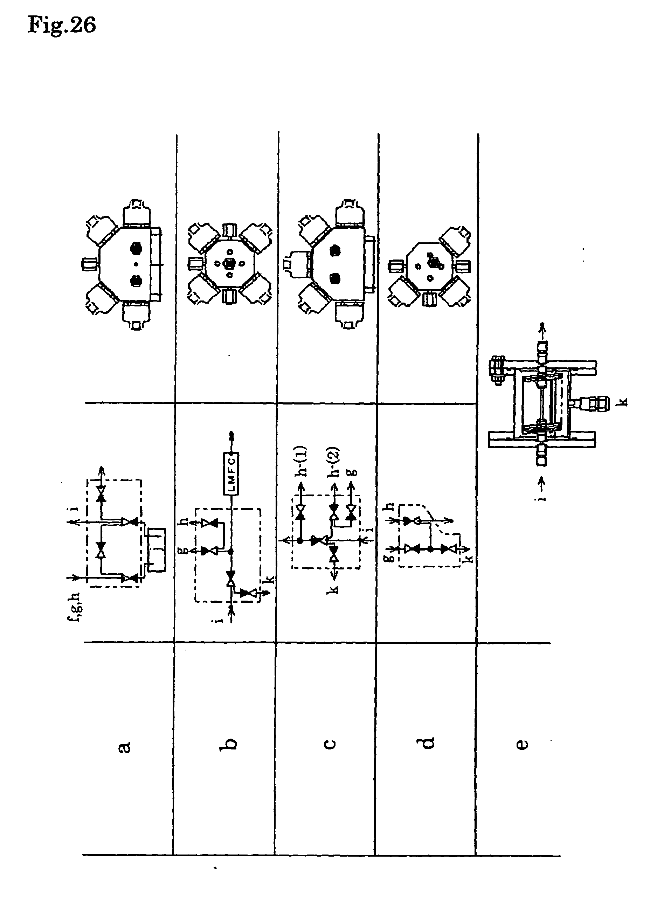

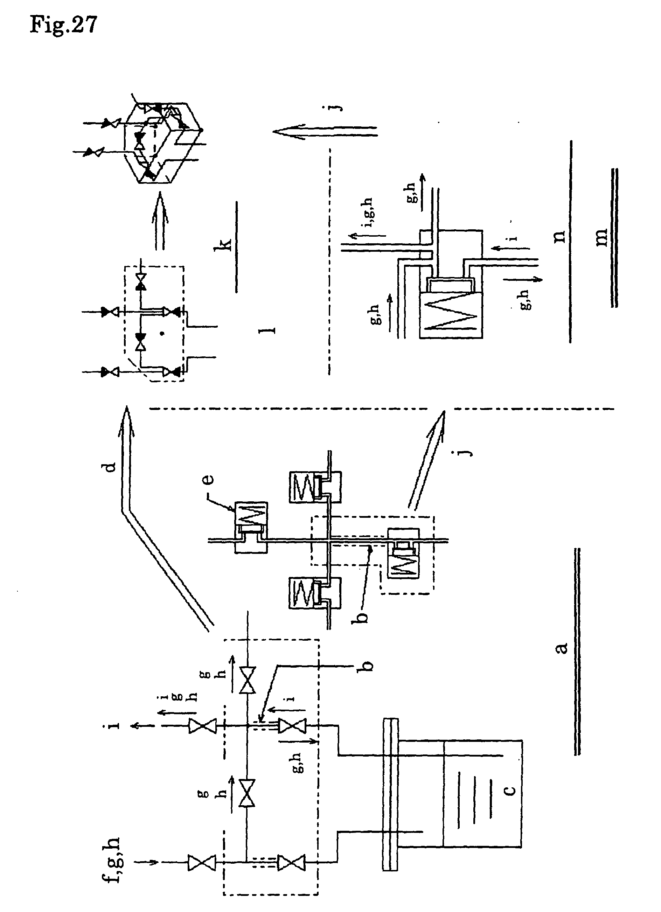

It is preferable to reduce a pipe arrangement capacity from the CVD raw material switching valve to the vaporizer as much as possible. For example, it is preferable to design as shown in FIGS. 26 and 27.

In particular, assuming that (Xcc/min.) means a flow quantity of the cleaning solvent, setting 8 Xcc or below is preferable, setting 2 Xcc or below is more preferable, and setting Xcc or below is further preferable. By setting the flow quantity in the above-described range, switching can be very rapidly carried out.

As a vaporizer in the present invention, it is preferable to adopt one characterized by comprising:
(1) a dispersion portion having
   a gas passage formed therein,
   a gas introduction opening from which a carrier gas is introduced to the gas passage,
   means for supplying a raw material solution to the gas passage,
   a gas outlet from which the carrier gas including the raw material solution is supplied to a vaporization portion, and
   means for cooling the gas passage; and
(2) a vaporization portion having
   a vaporization tube having one end connected to a reaction portion of an apparatus for film formation or of any other type and the other end connected to the gas outlet, and
   heating means for heating the vaporization tube,
   the vaporization portion heating the carrier gas which is supplied from the dispersion portion and includes the atomized raw material solution and vaporizing the carrier gas,
   the vaporizer having a radiation prevention portion which has a pore provided on the outer side of the gas outlet.

As a vaporizer in the present invention, it is preferable to adopt one characterized by comprising:
(1) a dispersion portion having
   a gas passage formed therein,
   a gas introduction opening from which a carrier gas is introduced to the gas passage,
   means for supplying a raw material solution to the gas passage, and
   a gas outlet from which the carrier gas including the raw material solution is supplied to a vaporization portion; and
(2) a vaporization portion having
   a vaporization tube having one end connected to a reaction portion of an apparatus for film formation or of any other type and the other end connected to the gas outlet, and
   heating means for heating the vaporization tube,
   the vaporization portion heating the carrier gas which is supplied from the dispersion portion and includes the raw material solution and vaporizing the carrier gas,
(3) the dispersion portion having a dispersion portion main body which has a cylindrical or conical hollow portion, and a rod which has an outside diameter smaller than an inside diameter of the cylindrical or conical hollow portion,
   the rod having one or more spiral grooves at the periphery thereof on the vaporizer side, and being inserted into the cylindrical or conical hollow portion, the inside diameter of the rod expanding in a tapered form toward the vaporizer side in some cases,
(4) a radiation prevention portion which has a pore on the gas outlet side and whose inside diameter expands in a tapered form toward the vaporizer side being provided on the outer side of the gas outlet.

As a vaporizer in the present invention, it is preferable to adopt one characterized by comprising:
(1) a dispersion portion having
   a gas passage formed therein,
   a gas introduction opening from which a carrier gas is introduced to the gas passage,
   means for supplying a raw material solution to the gas passage,
   a gas outlet from which the carrier gas including the raw material solution is supplied to a vaporization portion, and
   means for cooling the gas passage; and
(2) a vaporization portion having:
   a vaporization tube having one end connected to a reaction portion of an apparatus for film formation or of any other type and the other end connected to the gas outlet, and
   heating means for heating the vaporization tube,
   the vaporization portion heating the carrier gas which is supplied from the dispersion portion and includes the raw material solution and vaporizing the carrier gas,
   the vaporizer being able to add an oxidative gas, such as Ar, N₂, or He, to the carrier gas from the gas introduction opening or introduce the oxidative gas from a primary oxygen supply opening.

As a vaporizer in the present invention, it is preferable to use one characterized by comprising:
(1) a dispersion portion having
   a gas passage formed therein,
   a gas introduction opening from which a carrier gas is introduced to the gas passage,
   means for supplying a raw material solution to the gas passage,
   a gas outlet from which the carrier gas including the raw material solution is supplied to a vaporization portion, and
   means for cooling the gas passage; and
(2) a vaporization portion having
   a vaporization tube having one end connected to a reaction portion of an apparatus for film formation or of any other type and the other end connected to the gas outlet, and
   heating means for heating the vaporization tube,
   the vaporization portion heating the carrier gas which is supplied from the dispersion portion and includes the raw material solution and vaporizing the carrier gas,
   a radiation prevention portion which has a pore being provided on the outer side of the gas outlet,
   the vaporizer being able to introduce the carrier gas and an oxidative gas from the gas introduction opening.

As a vaporization method in the present invention, it is preferable to adopt one characterized in that a vaporization method in the vaporizer is a vaporization method which shears/atomizes the raw material solution to obtain a raw material mist by introducing the raw material solution in the gas passage and injecting the carrier gas toward the introduced raw material solution, and then supplies the raw material mist to the vaporization portion in order to vaporize this mist, and this method is a vaporization method which has oxygen contained in the carrier gas.

As a vaporizer in the present invention, it is preferable to adopt one characterized by having formed thereto
a plurality of solution passages through which raw material solutions are supplied,
a mixing portion which mixes the plurality of raw material solutions supplied from the plurality of solution passages,
a supply passage whose one end communicates with the mixing portion and which has an outlet which is on the vaporization side,
a gas passage which is arranged to spray a mixed raw material solution exiting from the mixing portion with the carrier gas or a mixed gas obtained from the carrier gas and oxygen in the supply passage, and
cooling means for cooling the gas passage.

As a disperser in the vaporizer, it is preferable to adopt one characterized by comprising:
a disperser having formed thereto,
a plurality of solution passages through which raw material solutions are supplied,
a mixing portion which mixes the plurality of raw material solutions supplied from the plurality of solution passages,
a supply passage whose one end communicates with the mixing portion and which has an outlet which is on the vaporization side,
a gas passage which is arranged to spray a mixed raw material solution exiting from the mixing portion with the carrier gas or a mixed gas obtained from the carrier gas and oxygen in the supply passage, and
cooling means for cooling the gas passage; and
a plurality of solution passages through which raw material solutions are supplied,
a mixing portion which mixes the plurality of raw material solutions supplied from the plurality of solution passages,
a supply passage whose one end communicates with the mixing portion and which has an outlet which is on the vaporization side,
a gas passage which is arranged to spray a mixed raw material solution exiting from the mixing portion with the carrier gas or a mixed gas obtained from the carrier gas and oxygen in the supply passage,
cooling means for cooling the gas passage,
a vaporization tube having one end connected to a reaction portion of an apparatus for film formation or of any other type and the other end connected to an outlet of the disperser, and
heating means for heating the vaporization tube,
the vaporization portion heating the carrier gas which is supplied from the dispersion portion and includes the raw material solutions and vaporizing the carrier gas,
a radiation prevention portion which has a pore being provided on the outer side of the gas outlet.

### Brief Description of Drawings

FIG. 1 is a cross-sectional view showing a primary part of an MOCVD vaporizer according to Embodiment 1;
FIG. 2 is an overall cross-sectional view of the MOCVD vaporizer according to Embodiment 1;
FIG. 3 is a system chart of an MOCVD;
FIG. 4 is a front view of a reserve tank;
FIG. 5 is a cross-sectional view showing a primary part of an MOCVD vaporizer according to Embodiment 2;
FIG. 6 is a cross-sectional view showing an MOCVD vaporizer according to Embodiment 3;
FIGS. 7(a) and (b) concern Embodiment 4 and are cross-sectional views showing modifications of a gas passage of the MOCVD vaporizer;
FIG. 8 is a cross-sectional view showing an MOCVD vaporizer according to Embodiment 5;
FIGS. 9 show a rod used in the MOCVD vaporizer according to Embodiment 5, in which (a) is a side view, (b) is an X-X cross-sectional view, and (c) is a Y-Y cross-sectional view;
FIG. 10 is a side view showing a modification of FIG. 9(a);
FIG. 11 is a graph showing an experimental result in Embodiment 6;
FIG. 12 is a side cross-sectional view showing Embodiment 8;
FIG. 13 is a conceptual view showing a gas supply system of Embodiment 8;
FIG. 14 is a cross-sectional view showing Embodiment 9;
FIG. 15 is a cross-sectional view showing a latest prior art;
FIGS. 16(a) and (b) are cross-sectional views showing a conventional MOCVD vaporizer;
FIG. 17 is a graph showing crystallization characteristics of an SBT thin film;
FIG. 18 is a graph showing polarization characteristics of a crystallized SBT thin film;
FIG. 19 is a detail view of the vaporizer;
FIG. 20 is a general view of the vaporizer;
FIG. 21 is a view showing an example of an SBT thin film CVD apparatus using the vaporizer;
FIG. 22 is a cross-sectional view showing a film formation device example;
FIG. 23 is a view showing a structure of heat transfer medium circulation used in FIG. 22;
FIG. 24 shows Example 1 of a solution vaporization type CVD apparatus which is designed in such a manner that a pipe arrangement capacity from a CVD raw material solution switching valve to a vaporizer becomes minimum;
FIG. 25 shows Example 2 of the solution vaporization type CVD apparatus which is designed in such a manner that a pipe arrangement capacity from a CVD raw material solution switching valve to a vaporizer becomes minimum;
FIG. 26 shows a design example of the CVD raw material solution switching valve which is designed in such a manner that a pipe arrangement capacity becomes minimum; and
FIG. 27 shows a design example of a container valve which is designed in such a manner that a pipe arrangement capacity becomes minimum.

### (Description of Reference Numerals)

Figure 2
   a: FILM FORMATION APPARATUS
   b: COOLING WATER
Figure 3
   a: RECOVERY SECTION
   b: REACTION SECTION
   c: SUPPLY SECTION
   d: EXHAUST GAS
   e: VAPORIZER
   f: MASS-FLOW CONTROLLER
   g: OXYGEN
   h: HEATED SECTION
Figure 4
   a: RAW MATERIAL SOLUTION
   b: ARGON
Figure 7
   a: GAS PASSAGE
Figure 12
   a: MOCVD APPARATUS
   b: COOLING WATER
Figure 13
   a: RECOVERY SECTION
   b: REACTION SECTION
   c: SUPPLY SECTION
   d: EXHAUST GAS
   e: VAPORIZER
   f: MASS-FLOW CONTROLLER
   g: OXYGEN
   h: HEATED SECTION
Figure 16
   a: METAL FILTER
Figure 19
   a: FIRST CARRIER
   b: RAW MATERIAL SOURCE INTRODUCING ORIFICE
   c: COOLING WATER
   d: SECOND MIXING SECTION & ATOMIZING NOZZLE PORTION
   e: SECOND CARRER
   f: FIRST MIXING SECTION
Figure 20
   a: SHEATH HEATER
   b: PERMA
   c: HEAT EXCHANGER
   d: VAPORIZATION SECTION PROPER DISTANCE AND TEMPERATURE
   e: MANTLE HEATER
   f: VAPORIZATION HEAD
   g: CONTROLLER
   h: PRESSURE GAGE
   i: VAPORIZATION SECTION AUTOMATIC PRESSURE REGULATING VALVE
   j: THERMOCOUPLE
   k: O₂ OR AIR (SWITCHING OVER)
   l: INTRODUCED GAS (SWIRL MIXING)
   m: HORIZONTAL SECTIONAL VIEW (GAS FLOW IMAGE)
   n: THERMOCOUPLE
   o: SHOWER HEAD
   p: HOT WALL CHAMBER
Figure 21
   a: DEGASSING SYSTEM
   b: N₂, Ar OR He
   c: HEAT EXCHANGER
   d: SUBSTRATE (4" TO 8")
   e: LOAD LOCK CHAMBER
   f: WAFER CONVEYING MECHANISM
   g: LOADER
   h: GATE VALVE
   i: EXHAUST GAS
   j: VAPORIZER
   k: PROCESS CHAMBER
Figure 24
   a: HEAT EXCHANGER
   b: PROCESS CHAMBER
   c: VAPORIZATION CHAMBER
   d: SUBSTRATE
   e: EXHAUST
   f: LOAD LOCK CHAMBER
   g: LOADER
Figure 25
   a: HEAT EXCHANGER
   b: PROCESS CHAMBER
   c: VAPORIZATION CHAMBER
   d: SUBSTRATE
   e: EXHAUST
   f: LOAD LOCK CHAMBER
   g: LOADER
Figure 26
   a: CONTAINER VALVE, BLOCKING
   b: LMFC, BLOCKING
   c: VAPORIZATION HEAD, BLOCKING
   d: CLEANING REPLACING VALVE, BLOCKING
   e: EACH CONTAINER DEAERATION SYSTEM MOUNTED
   f: PRESSURIZATION
   g: PURGE
   h: CLEANING
   i: SOURCE
   j: CONTAINER
   k: VACUUM
Figure. 27
   a: CONVENTIONAL VALVE AND ARRANGEMENT PRESSURIZATION PURGE CLEANING
   b: DEAD SPACE
   c: SOURCE TANK
   d: FORMING ONE BLOCK
   e: AIR OPERATION VALVE
   f: PRESSURIZATION
   g: PURGE
   h: CLEANING
   i: SOURCE
   j: DEAD SPACE MINIMIZATION
   k: FORMING ONE BLOCK
   l: BEST REPLACE ABILITY CAN BE OBTAINED WITH MINIMUM DEAD SPACE BY PLANETARY-ARRANGING NECESSARY NUMBER OF AIR OPERATION VALVES ON SAME LEVEL IN ONE BLOCK.
   m: FORMING BLOCK VALVE
   n: MINIMIZING DEAD SPACE
      1 dispersion portion main body,
      2 gas passage,
      3 carrier gas,
      4 gas introduction opening,
      5 raw material solution,
      6 raw material supply hole,
      7 gas outlet,
      8 dispersion portion,
      9a, 9b, 9c, 9d screw,
      10 rod,
      18 means for cooling (coolant),
      20 vaporization tube,
      21 heating means (heater),
      22 vaporization portion,
      23 connection portion,
      24 joint,
      25 oxygen introducing means (primary oxygen (oxidative gas) supply opening,),
      26 raw material supply inlet,
      30a, 30b, 30c, 30d massflow controller,
      31a, 31b, 31c, 31d valve,
      32a, 32b, 32c, 32d reserve tank,
      33 carrier gas cylinder,
      42 exhaust opening,
      40 valve,
      44 reaction tube,
      46 gas pack,
      51 taper,
      70 groove,
      101 pore,
      102 radiation prevention portion,
      200 oxygen introducing means (secondary oxygen (oxidative gas), carrier supply opening,),
      301 upstream ring,
      302 downstream ring,
      303a, 303b heat transfer passage,
      304 heat exchange plate,
      304a gas vent gas nozzle,
      306 exhaust opening,
      308 orifice,
      312 substrate heater,
      320 heat transfer medium inlet,
      321 heat transfer medium outlet,
      390 incoming heat transfer medium,
      391 outgoing heat transfer medium,
      3100 silicon substrate,

### Best Mode for Carrying Out of the Invention

### (Embodiment 1)

FIG. 1 shows an MOCVD vaporizer according to Embodiment 1.

This example comprises:
a dispersion portion 8 which has:
   a gas passage 2 formed in a dispersion portion main body 1 constituting a dispersion portion, and a gas introduction opening 4 from which a pressurized carrier gas 3 is introduced to the gas passage 2,
means (raw material supply hole) 6 for supplying a raw material solution 5 to the carrier gas passing through the gas passage 2, and atomizing the raw material solution 5,
a gas outlet 7 which is used to supply the carrier gas (raw material gas) including the atomized raw material solution 5 to a vaporization portion 22,
means (coolant) 18 for cooling the carrier gas flowing through the gas passage 2; and
a vaporization portion 22 which has:
a vaporization tube 20 having one end connected with a reaction tube of the MOCVD apparatus and the other end connected with the gas outlet 7 of the dispersion portion 8, and
heating means (heater) 21 for heating the vaporization tube 20, the vaporization portion heating the carrier gas, in which the raw material solution is dispersed, supplied from the dispersion portion 8 and vaporizing it,
wherein a radiation prevention portion 102 having a pore 101 is provided on the outer side of the gas outlet 7.

This embodiment will now be described in more detail hereinafter.

In the illustrated example, the inside of the dispersion portion main body 1 is a cylindrical hollow portion. A rod 10 is fitted in the hollow portion, and an inner wall of the dispersion main body and the rod 10 form the gas passage 2. It is to be noted that the hollow portion is not restricted to the cylindrical shape, and it may have any other shape. For example, a conical shape is preferable. As an angle of a circular cone of the conical hollow portion, 0 to 45° is preferable, and 8 to 20° is more preferable. This can be likewise applied to any other embodiment.

It is to be noted that 0.10 to 0.5 mm² is preferable as a cross-sectional area of the gas passage. If the cross-sectional area is less than 0.10 mm², processing is difficult. If the cross-sectional area exceeds 0.5 mm², a large flow quantity of the carrier gas having a high pressure must be used in order to increase a speed of the carrier gas.

When a large flow quantity of the carrier gas is used, a large vacuum pump with a large capacity is required in order to maintain a reaction chamber in a pressure reduction state (e.g., 1.0 Torr). Since it is difficult to adopt a vacuum pump whose exhaust capacity exceeds 10000 liter/min. (at, 1.0 Torr), an appropriate flow quantity, i.e., a gas passage area of 0.10 to 0.5 mm² is preferable in order to achieve industrial practical applications.

The gas introduction opening 4 is provided at one end of this gas passage 2. A carrier gas (e.g., N₂, Ar, He) source (not shown) is connected with the gas introduction opening 4.

The raw material supply opening 6 which communicates with the gas passage 2 is provided to a substantially central side portion of the dispersion portion main body 1 so that the raw material solution 5 can be introduced into the gas passage 2 and the raw material solution 5 can be dispersed in the carrier gas passing through the gas passage 2, thereby obtaining a raw material gas.

The gas outlet 7 communicating with the vaporization tube 20 of the vaporization portion 22 is provided at one end of the gas passage 2.

A space 11 through which a coolant 18 is caused to flow is formed in the dispersion portion main body 1, and the carrier gas flowing through the gas passage 2 is cooled down by passing the coolant 8 through this space. Alternatively, for example, a Peltier element or the like may be installed in place of this space in order to cool down the gas. Since the inside of the gas passage 2 of the dispersion portion 8 is thermally affected by the heater 21 of the vaporization portion 22, vaporization of a solvent alone occurs without generating simultaneous vaporization of the solvent the raw material and an organic metal complex in the gas passage 2. Thus, vaporization of the solvent alone is avoided by cooling the carrier gas which flows through the gas passage 2 and in which the raw material solution is dispersed. In particular, cooling on the downstream side away from the raw material supply hole 6 is important, and cooling on at least the downstream side of the raw material supply hole 6 is performed. A cooling temperature is a temperature which is not more than a boiling point of the solvent. For example, in case of THF, a cooling temperature is not more than 67°C. In particular, a temperature at the gas outlet 7 is important.

In this example, the radiation prevention portion 102 having the pore 101 is provided on the outer side of the gas outlet 7. It is to be noted that reference numerals 103 and 104 denote sealing members such as an O ring. Forming this radiation prevention portion 102 by using, e.g., Teflon (registered trademark), stainless, ceramics or the like can suffice. Further, it is preferable to constitute it by using a material which is superior in thermal conductivity.

According to the present inventor's knowledge, heat in the vaporization portion excessively heats the gas in the gas passage 2 through the gas outlet 7 as radiant heat in the prior art. Therefore, even if cooling is effected by using the coolant 18, a low-fusing point component in the gas is separated out in the vicinity of the gas outlet 7.

The radiation prevention portion is a member which prevents such radiant heat from being propagated to the gas. It is, therefore, preferable to set a cross-sectional area of the pore 101 smaller than a cross-sectional area of the gas passage 2. It is preferable to set it to 1/2 or below, and more preferable to set it to 1/3 or below. Furthermore, reducing a size of the pore is preferable. In particular, it is preferable to reduce the pore to have a size with which a flow rate of the injected gas becomes a subsonic speed.

Moreover, it is preferable for a length of the pore to be fivefold or above of the size of the pore, and it is more preferable for the same to be tenfold or above.

Additionally, clogging due to carbides in the gas passage (gas outlet in particular) is prevented from occurring with respect to a use for a long time by cooling the dispersion portion.

The dispersion portion main body 1 is connected with the vaporization tube 20 on the downstream side of the dispersion portion main body 1. A connection between the dispersion portion main body 1 and the vaporization tube 20 is achieved by a joint 24, and this portion serves as a connection portion 23.

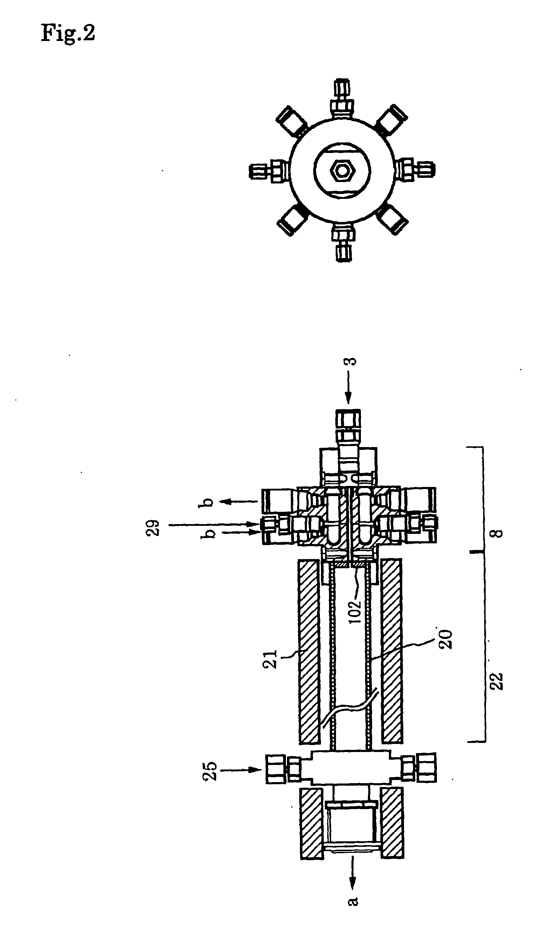

FIG. 2 shows a general view. The vaporization portion 22 comprises the vaporization tube 20 and the heating means (heater) 21. The heater 21 is a heater which heats and vaporizes the carrier gas which flows through the vaporization tube 20 and in which the raw material solution is dispersed. Although the heater 21 is constituted by attaching a cylindrical heater or a mantle heater to the outer periphery of the vaporization tube 20 in the prior art, a method which uses a liquid or gas having a large heat capacity as a heat transfer medium is most excellent in order to perform heating so as to obtain an even temperature with respect to a lengthwise direction of the vaporization tube, and hence this method is adopted.

As the vaporization tube 20, it is preferable to use stainless steel of, e.g., SUS316L. Although it is good enough to appropriately determine a size of the vaporization tube 20 as a length with which a temperature of the vaporized gas is sufficiently increased, using a vaporization tube having an outside diameter of 3/4 inch and a length of several-hundred mm can suffice when vaporizing, e.g., 0.04 ccm of an SrBi₂Ta₂O₉ raw material solution.

Although a downstream side end of the vaporization tube 20 is connected with the reaction tube of the MOCVD apparatus, an oxygen supply opening 25 as oxygen supplying means is provided to the vaporization tube 20 in this example so that oxygen heated to a predetermined temperature can be mixed in the carrier gas.

Supply of the raw material solution to the vaporizer will be first described.

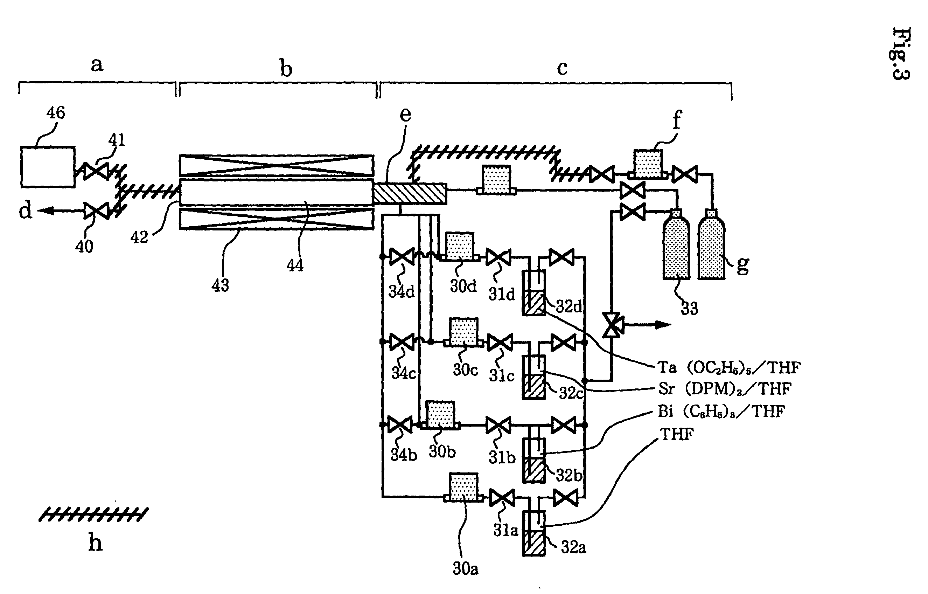

As shown in FIG. 3, respective reserve tanks 32a, 32b, 32c and 32d are connected with the raw material supply opening 6 through massflow controllers 30a, 30b, 30c and 30d and valves 31a, 31b, 31c and 31d.

Additionally, a carrier gas cylinder 33 is connected with each of the reserve tanks 32a, 32b, 32c and 32d.

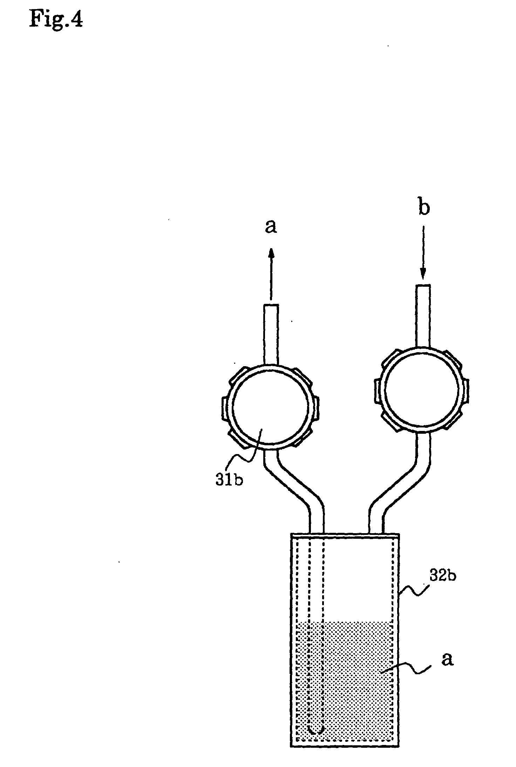

FIG. 4 shows the detail of the reserve tank.

The raw material solution is filled in the reserve tank, and, for example, 1.0 to 3.0 kgf/cm² of a carrier gas (e.g., an inert gas Ar, He, Ne) is supplied into each reservoir tank (which has an internal volume of 300 cc and is made by SUS). Since the inside of the reserve tank is pressurized by the carrier gas, the raw material solution is pushed up in the tube on the side where it is in contact with the solution, supplied to a liquid massflow controller (which is made by STEC and has a full-scale flow quantity of 0.2 cc/min) by the pressure, a flow quantity is controlled in this controller, and the raw material solution is transported to the raw material supply hole 6 from a raw material supply inlet 29 of the vaporizer.

The raw material solution is transported to the reaction portion by the carrier gas controlled to have a fixed flow quantity by the massflow controller. At the same time, oxygen (oxidizer) controlled to have a fixed flow quantity by a massflow controller (which is made by STEC and has a full-scale flow quantity of 2 L/min) is also transported to the reaction portion.

Since the raw material solution has therein a liquid or solid type organic metal complex dissolved in THF as a solvent or any other solvent at an ordinary temperature, the organic metal complex is separated out due to evaporation of the THF solvent and finally enters a solid state if the raw material solution is left as it stands. It can be, therefore, assumed that tube cloggings or the like are generated in the tube brought into contact with the undiluted solution. Accordingly, it can be considered that cleansing the inside of the tube or of the vaporizer after a film formation operation by using THF or any other solvent is effective to suppress cloggings of the tube, and hence a cleansing line is provided. Cleansing includes a raw material container replacing operation and is performed in a section from the container outlet side to the vaporizer, and a portion adapted to each operation is washed away by using the solvent.

The valves 31b, 31c and 31d are opened, and the carrier gas is supplied into the reserve tanks 32b, 32c and 32d by using the pressure. The raw material solution is supplied to a massflow controller (which is made by STEC and has a full-scale flow quantity of 0.2 cc/min) by the pressure, a flow quantity is controlled in this controller, and the solution raw material is transported to the raw material supply hole 6 of the vaporizer.

On the other hand, the carrier gas is introduced from the gas introduction opening of the vaporizer. It is preferable to set a maximum pressure on the supply opening side to 3 kgf/cm² or below, a maximum flow quantity which can be passed is approximately 1200 cc/min at this time, and a passing flow rate in the gas passage 2 reaches a hundred and several-ten m/s.

When the raw material solution is introduced from the raw material supply hole 6 into the carrier gas flowing through the gas passage 2 in the vaporizer, the raw material solution is sheared by a high-speed flow of the carrier gas and formed into ultra-fine particles. As a result, the raw material solution is dispersed in the carrier gas in the form of ultra-fine particles. The carrier gas (raw material gas) in which the raw material solution is dispersed in the ultra-fine particle state is atomized and discharged to the vaporization portion 22 while maintaining a high speed. An angle formed by the gas passage and the raw material supply hole is optimized. If the carrier flow path and the raw material solution introduction opening form a sharp angle (30 degrees), the solution is pulled by the gas. If the angle is not smaller than 90 degrees, the solution is pushed by the gas. An optimum angle is determined based on the viscosity/flow quantity of the solution. If the viscosity or the flow quantity is large, making the angle sharper allows the solution to smoothly flow. In cases where an SBT film is formed by using hexane as a solvent, since both the viscosity and the flow quantity are small, an angle of approximately 84 degrees is preferable.

Three types of the raw material solutions controlled to have a fixed flow quantity flow into the gas passage 2 from the raw material supply hole 6 through the respective raw material supply inlets 29, move in the gas passage together with the carrier gas which has become a high-speed air current, and are then discharged into the vaporization portion 22. In the dispersion portion 8, since the raw material solution is likewise heated by heat from the vaporization portion 22 and evaporation of the solvent such as THF is facilitated, a section from the raw material supply inlet 29 to the raw material supply hole 6 and a section of the gas passage 2 are cooled by using water or any other cooling medium.

Vaporization of the raw material solution discharged from the dispersion portion 8 in a state that it is dispersed in the carrier gas in the form of fine particles is facilitated while the raw material solution is transported in the vaporization tube 20 heated to a predetermined temperature by a heater 21, and the raw material solution becomes a mixed gas due to mixing of oxygen heated to a predetermined temperature which is supplied from an oxygen supply opening 25 provided immediately before reaching the reaction tube of the MOCVD and flows into the reaction tube. It is to be noted that evaluation was made by analyzing a reaction conformation of the vaporized gas in place of forming a film.

A vacuum pump (not shown) was connected from an exhaust opening 42, impurities such as water contents in the reaction tube 44 were removed by a pressure reduction operation for approximately 20 minutes, and a valve 40 on the downstream side of the exhaust opening 42 was closed.

Approximately 400 cc/min of a coolant of was caused to flow through the vaporizer. On the other hand, 3 kgf/cm² of the carrier gas was caused to flow at 495 cc/min and the reaction tube 44 was sufficiently filled with the carrier gas. Thereafter, the valve 40 was opened. A temperature at the gas outlet 7 was lower than 67°C.

The inside of the vaporizer 20 was heated to 200°C, a section from the reaction tube 44 to the gas pack 46 and the gas pack were heated to 100°C, and the inside of the reaction tube 44 was heated to 300°C to 600°C.

The inside of the reserve tank was pressurized by the carrier gas, and a predetermined liquid was passed by using the massflow controller.

Sr(DPM)₂, Bi(C₆H₅)₃, and Ta(OC₂H₅)₅ and THF were caused to flow based on flow quantities of 0.04 cc/min, 0.08 cc/min, 0.08 cc/min and 0.2 cc/min, respectively.

After 20 minutes, a valve provided immediately before the gas pack 46 was opened, a resultant product was recovered into the gas pack 46, it was analyzed by using a gas chromatograph, and whether the detected product matches with a product in a reaction formula examined based on a reactor theory was checked. As a result, in this example, the detected product matched with the product in the reaction formula examined based on the reactor theory well.

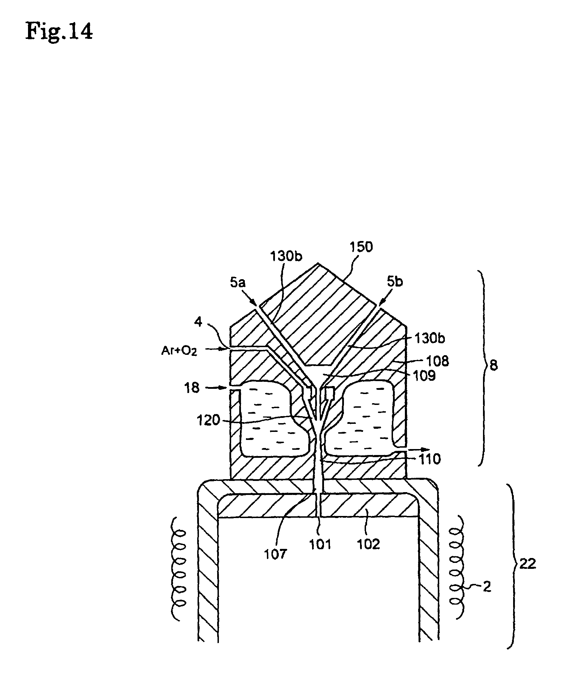

Further, an attachment quantity of a carbide on the outer surface of the dispersion portion main body 1 on the gas outlet 7 side was measured. As a result, an attachment quantity of the carbide was very small, and it was much smaller than that obtained by using the apparatus shown in FIG. 14.

It is to be noted that if a metal as film raw material is mixed or dissolved in the solvent in order to obtain a raw material solution, it is general that the metal becomes a complex and enters a liquid/liquid state (complete solvent liquid) in the raw material solution. However, the present inventor has examined the raw material solution in great detail and found that the metal complex is not necessarily in a loose molecular state and the metal complex itself may exist as fine particles having a size of 1 to 100 nm in the solvent or it may partially exist in a solid/liquid state. Although it can be considered that clogging in vaporization is particularly apt to occur when using the raw material solution which is in such a state, using the vaporizer according to the present invention does not result in occurrence of clogging even if the raw material solution in such a state is used.

Furthermore, in a stock solution of the raw material solution, fine particles tend to settle out on a bottom portion due to their gravitational force. Thus, producing a convection current in the stock solution by heating the bottom portion (to a temperature which is not more than an evaporating point of the solvent) and evenly dispersing fine particles are preferable for prevention of clogging. Moreover, it is preferable to heat the bottom portion while cool down the side surface of the top face of the container. Of course, heating is performed at a temperature which is not more than the evaporating temperature of the solvent.

Incidentally, it is preferable to set or control the heater in such a manner that a heating calorie in an upper area of the vaporization tube becomes larger than a heating calories in a downstream area. That is, since the gas subjected to water cooling is emitted from the dispersion portion, it is preferable to provide the heater which sets or controls to increase a heating calories in the upper area of the vaporization tube and reduce a heating calorie in the downstream area.

### (Embodiment 2)

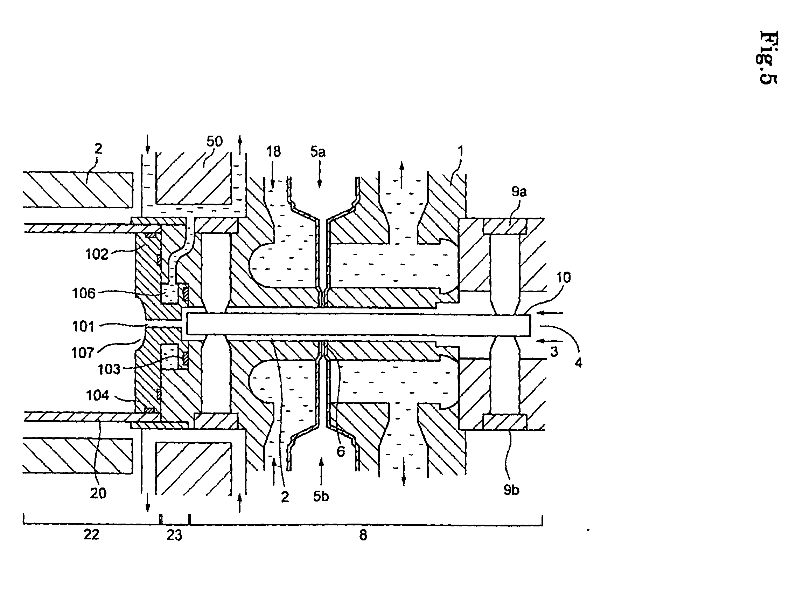

FIG. 5 shows an MOCVD vaporizer according to Embodiment 2.

In this example, a coolant passage 106 is formed at the outer periphery of the radiation prevention portion 102, and cooling means 50 is provided at the outer periphery of the connection portion 23, thereby cooling down the radiation prevention portion 102.

Further, a depression 107 is provided around an outlet of the pore 101.

Any other portion is the same as Embodiment 1.

In this example, it was observed that matching of a detected product with a product in the reaction formula examined based on the reactor theory is better than that in Embodiment 1.

Furthermore, in regard to a result of measuring an attachment quantity of the carbide on the outer surface of the dispersion portion main body 1 on the gas outlet 7 side, the attachment quantity was approximately 1/3-fold of that in Embodiment 1.

### (Embodiment 3)

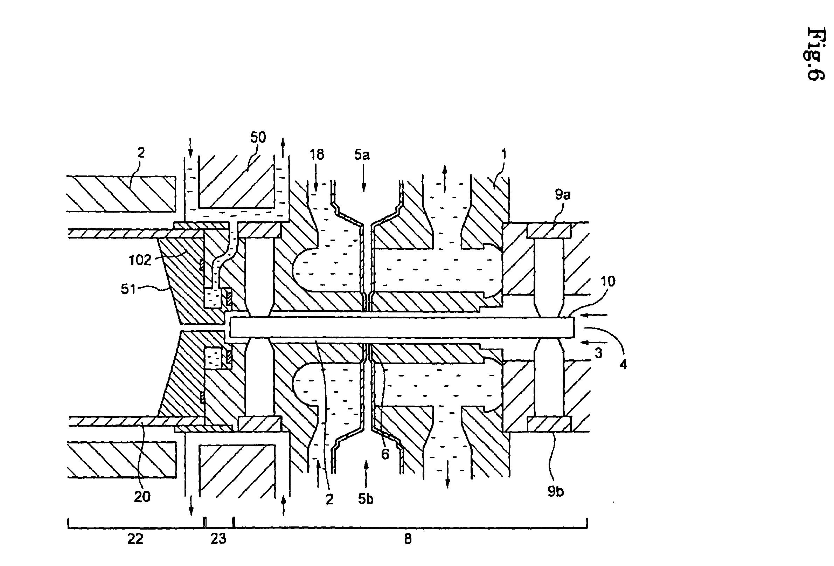

FIG. 6 shows an MOCVD vaporizer according to Embodiment 3.

In this example, a taper 51 is provided to the radiation prevention portion 102. A dead zone at any other portion is eliminated by using this taper 51, thereby preventing the raw material from being stored.

Any other point is the same as Embodiment 2.

In this example, it was observed that matching of a detected product with a product in the reaction formula examined based on the reactor theory is better than that in Embodiment 2.

Moreover, in regard to a result of measuring an attachment quantity of a carbide on the outer surface of the dispersion portion main body 1 on the gas outlet 7 side, the attachment quantity of the carbide was close to zero.

### (Embodiment 4)

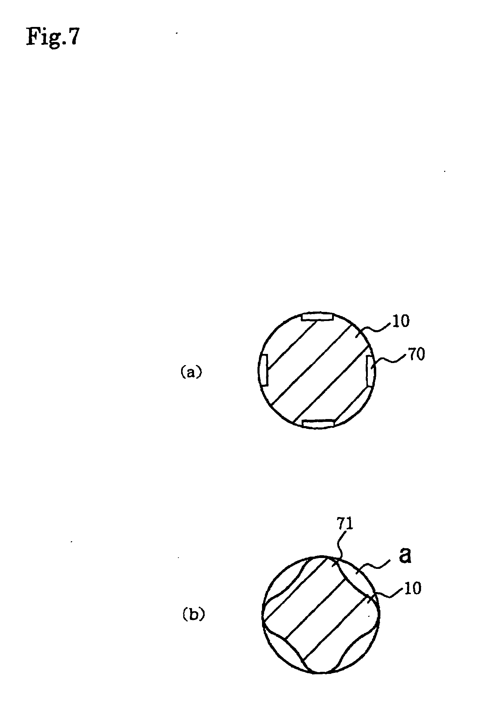

FIG. 7 shows a modified embodiment of the gas passage.

In FIG. 7(a), grooves 70 are formed on the surface of the rod 10, and an outside diameter of the rod 10 is substantially the same as an inside diameter of a hole formed in the dispersion portion main body 1. Therefore, the rod 10 can be arranged in the hole without generating the eccentricity by just fitting the rod 10 in the hole. Additionally, screws and the like do not have to be used. This groove 70 serves as a gas passage.

It is to be noted that a plurality of grooves 70 may be formed in parallel with a central axis in the longitudinal direction of the rod 10, but they may be formed in the spiral form on the surface of the rod 10. When the spiral form is adopted, a raw material gas which is superior in evenness can be obtained.

FIG. 7(b) shows an example in which a mixing portion is provided at an end portion of the rod 10. A maximum diameter at the end portion is substantially the same as an inside diameter of a hole formed in the dispersion portion main body 1. A space formed by the rod end portion and the inner surface of the hole function as a gas passage.

It is to be noted that the examples shown in (a) and (b) are examples in which the surface of the rod 10 is processed, but of course rod having a circular cross-sectional shape may be used as the rod and a concave portion may be provided to the hole, thereby obtaining a gas passage.

It is preferable to set the rod based on approximately H7 x h6 to JS 7 which is defined in JIS, for example.

### (Embodiment 5)

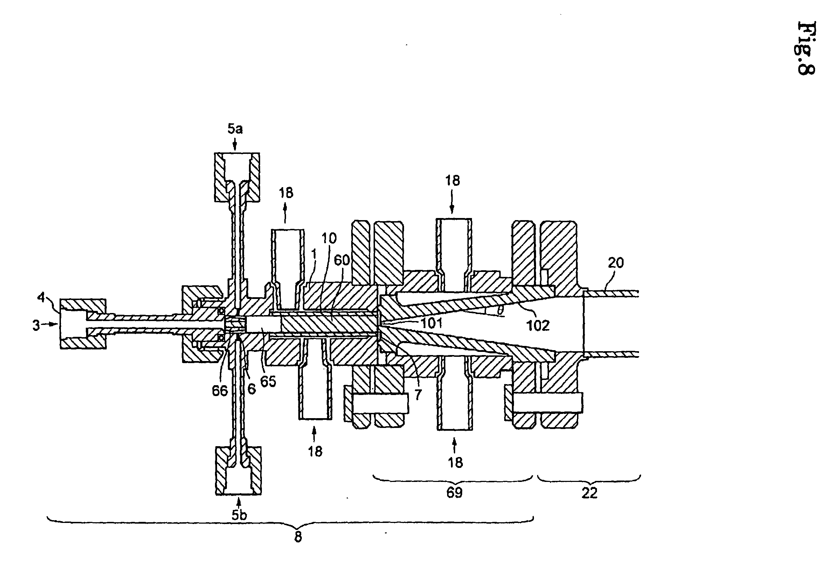

Embodiment 5 will now be described with reference to FIG. 8.

An MOCVD vaporizer according to this example comprises:
a dispersion portion 8 having
a gas passage formed therein,
a gas introduction opening 4 from which a pressurized carrier gas 3 is introduced to the gas passage,
means for supplying raw material solutions 5a and 5b to the gas passage, and
a gas outlet 7 from which the carrier gas including the raw material solutions 5a and 5b is supplied to a vaporization portion 22; and
a vaporization portion 22 having
a vaporization tube 20 having one end connected to a reaction tube of the MOCVD apparatus and the other end connected to the gas outlet 7, and
heating means for heating the vaporization tube 20,
the vaporization portion 22 heating the carrier gas which is supplied from the dispersion portion 8 and includes the raw material solutions and vaporizing the carrier gas,
the dispersion portion 8 having a dispersion portion main body 1 which has a cylindrical hollow portion, and a rod 10 which has an outside diameter smaller than an inside diameter of the cylindrical hollow portion,
the rod 10 having one or more spiral grooves 60 at the periphery thereof on the vaporizer 22 side,
the rod 10 being inserted into the cylindrical hollow portion,
radiation prevention portion 101 which has a pore 101 and whose inside diameter expands in a tapered form toward the vaporizer 22 side being provided on the outer side of the gas outlet 7.

When the raw material solution 5 is supplied to the gas passage through which the carrier gas having a high speed flows, the raw material solution is sheared/atomized. That is, the raw material solution as a liquid is sheared and turned into particles by a high-speed current of the carrier gas. The raw material solution turned into particles are dispersed in the carrier gas in a particle state. This point is the same as Embodiment 1.

It is to be noted that the following conditions are preferable in order to optimally perform shearing/atomization.

It is preferable to supply the raw material solution 5 based on a flow quantity of 0.005 to 2 cc/min, more preferable to supply it based on a flow quantity of 0.005 to 0.02 c/min, and further preferable to supply it based on a flow quantity of 0.1 to 0.3 cc/min. When a plurality of raw material solutions (including a solvent) are simultaneously supplied, a total quantity of these solutions is used.

Further, it is preferable to supply the carrier gas at a speed of 10 to 200 m/sec, and more preferable to supply it at a speed of 100 to 200 m/sec.

It is needless to say that a raw material solution flow quantity and a carrier gas flow quantity have a correlation, realize optimum shearing/atomization, and select a flow path cross-sectional area and shape with which ultra-fine particle mists can be obtained.

In this example, since spiral grooves 60 are formed on the periphery of the rod 10 and a gap space exists between the dispersion portion main body 1 and the rod 10, the carrier gas including the atomized raw material solution moves straight in this gasp space as a straight current and forms a swirling current along the spiral grooves 60.

The present inventor has discovered that the atomized raw material solution is evenly dispersed in the carrier gas in a state that both the straight current and the swirling current exist in this manner. A reason why even dispersion is obtained when both the straight current and the swirling current exist is not necessarily clear, but the following can be considered. A centrifugal force acts on a flow due to existence of the swirling current, and a secondary flow is generated. This secondary flow facilitates mixing of the raw material and the carrier gas. That is, it can be considered that a secondary derived flow is generated in a direction orthogonal to the flow due to the centrifugal effect of the swirling current, and the atomized raw material solution is evenly dispersed in the carrier gas.

This embodiment will now be described in more detail hereinafter.

This embodiment is configured to supply four types of raw material solutions 5a, 5b, 5c and 5d (5a, 5b and 5c are organic metal raw materials, and 5d is a solvent raw material such as THF) into the gas passage, as an example.

In order to mix the carrier gas including the atomized raw material solution in the super-fine particle state (which will be referred to as a "raw material gas"), a part without spiral grooves is provided at a downstream part of a portion of the rod 10 corresponding to the raw material supply hole 6 in this example. This part serves as a pre-mixing portion 65. In the pre-mixing portion 65, the three types of the organic metal raw material gasses are mixed to some degree, and turned into a complete mixed raw material gas in an area having a spiral structure on the downstream side. In order to obtain the even mixed raw material gas, as a length of this mixing portion 65, 5 to 20 mm is preferable, and 8 to 15 mm is more preferable. In case of a length out of this range, only one of the three types of organic metal raw material gasses, i.e., the mixed raw material gas having a high concentration may be possibly supplied to the vaporization portion 22.

In this example, a parallel portion 67 and a taper portion 58 are provided to an end portion 66 of the rod 10 on the up stream side. A parallel portion having the same inside diameter as an outside diameter of the parallel portion 67 of the rod 10 and a taper portion having the same taper as that of the rod 10, which correspond to the parallel portion 67 and the taper portion 58, are likewise provided to a cylindrical hollow portion of the dispersion portion main body 1. Therefore, when the rod 10 is inserted from the upper left side in the drawing, the rod 10 is held in the hollow portion of the dispersion portion main body 1.

In this example, as different from Embodiment 1, a taper is provided to hold the rod 10, movement of the rod 10 can be prevented even if a carrier gas having a higher pressure than 3 kgf/cm2 is used. That is, adopting the holding technique shown in FIG. 8 can cause a carrier gas having a pressure not less than 3 kg/cm² to flow. As a result, a cross-sectional area of the gas passage can be reduced, and the carrier gas having a higher speed can be supplied with a small quantity of the gas. That is, the carrier gas having a high speed of 50 to 300 mm/s can be supplied. In the other embodiments mentioned above, the same advantages can be obtained by adopting this holding technique.

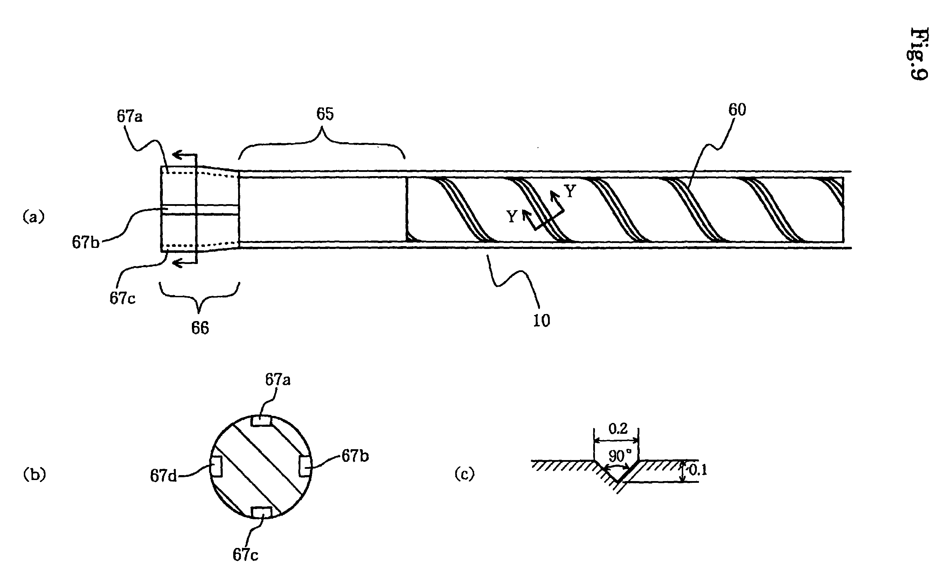

It is to be noted that grooves 67a, 67b, 67c and 67d as passages of the carrier gas are formed to the part of the rod 10 corresponding to the raw material supply hole 6 as shown in FIG. 9(b). As a depth of the respective grooves 67a, 67b, 67c and 67, 0.005 to 0.1 mm is preferable. If the depth is less than 0.005 mm, the groove forming processing becomes difficult. Further, 0.01 to 0.05 is more preferable. By setting the depth in this range, clogging or the like is hard to be generated. Furthermore, a high-speed current can be readily obtained.

As to holding of the rod 10 and formation of the gas passage, the structure shown in FIG. 1 in Embodiment 1 and any other structures can be adopted.

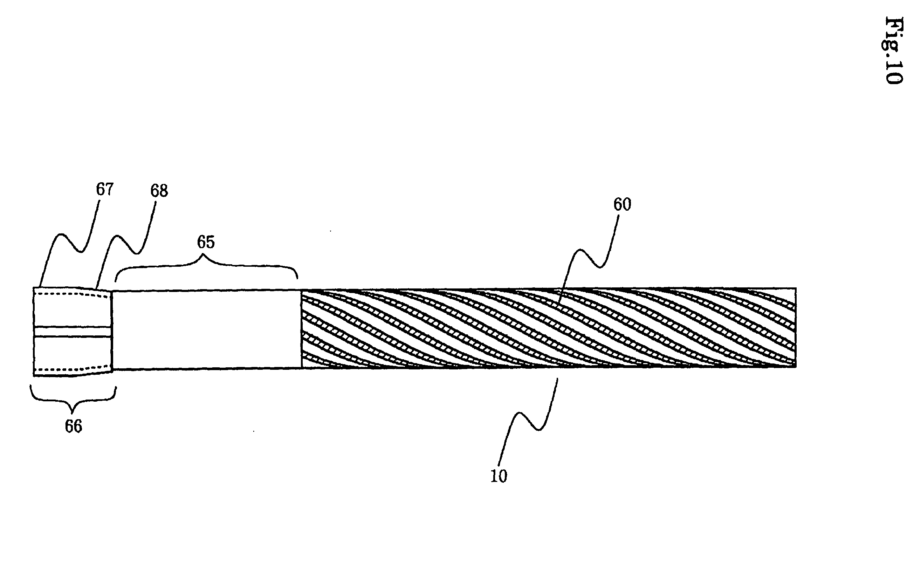

As shown in FIG. 9(a), the number of the spiral groove 60 may be one, but a plurality of spiral grooves may be used as shown in FIG. 10. Moreover, the plurality of spiral grooves are formed, they may cross each other. When the plurality of spiral grooves cross each other, a further evenly dispersed raw material gas can be obtained. However, it is determined that a cross-sectional area with which a gas flow rate which is not more than 10 m/sec can be obtained with respect to each groove is used.

The spiral groove 60 is not restricted to specific dimensions/shapes, and the dimension/shape shown in FIG. 9(c) can be taken as an example.

It is to be noted that the gas passage is cooled by using the coolant 18 in this example as shown in FIG. 8.

Additionally, in this example, an extended portion 69 is independently provided short of the inlet of the dispersion portion 22, and a longitudinal radiation prevention portion 102 is arranged in this extended portion.

A pore 101 is formed on the gas outlet 7 side of the radiation prevention portion, and its inside diameter is extended toward the vaporizer side in the tapered form.

This extended portion 69 is also the portion which prevents the raw material gas from being stored, which has been described in conjunction with Embodiment 3. Of course, the extended portion 69 does not have to be independently provided, and it may have an integrated structure as shown in FIG. 6.

As an extension angle θ in the extended portion 69, an angle of 5 to 10 degrees is preferable. If θ falls in this range, the raw material gas can be supplied to the dispersion portion without destroying the swirling current. Further, if θ falls in this range, a fluid resistance obtained by extension becomes minimum, existence of the dead becomes minimum, and existence of eddy currents due to existence of the dead zones can be minimized. It is to be noted that, as θ, an angle of 6 to 7 degrees is more preferable. Incidentally, in the case of the embodiment shown in FIG. 6, a preferable range of θ is the same.

### (Embodiment 6)

The raw material solutions and the carrier gas were supplied by using the apparatus shown in FIG. 8 under the following conditions, and the homogeneity in the raw material gas was checked.

Raw material solution introducing quantities:
Sr(DPM)₂ 0.04 cc/min;
Bi(C₆H₅)₃ 0.08 cc/min;
Ta(OC₂H₅)₅ 0.08 cc/min; and
THF 0.2 cc/min.

Carrier gas: nitrogen gas 10 to 350 m/s

As the vaporizer, the apparatus shown in FIG. 8 was used. As the row, however, there was used a rod having no spiral groove formed to the rod shown in FIG. 9.

The raw material solutions were supplied from the raw material supply hole 6, and a speed of the carrier gas was changed in many ways. It is to be noted that, from the raw material supply hole 6, Sr(DPM)₂ was supplied to the groove 67a, Bi(C₆H₅)₃ was supplied to the groove 67b, Ta(OC₂H₅)₅ was supplied to the groove 67c, and a solvent such as THF was supplied to the groove 67d.

Heating in the vaporization portion was not carried out, the raw material gas was taken at the gas outlet 7, and a particle size of the raw material solutions in the sampled raw material gas was measured.

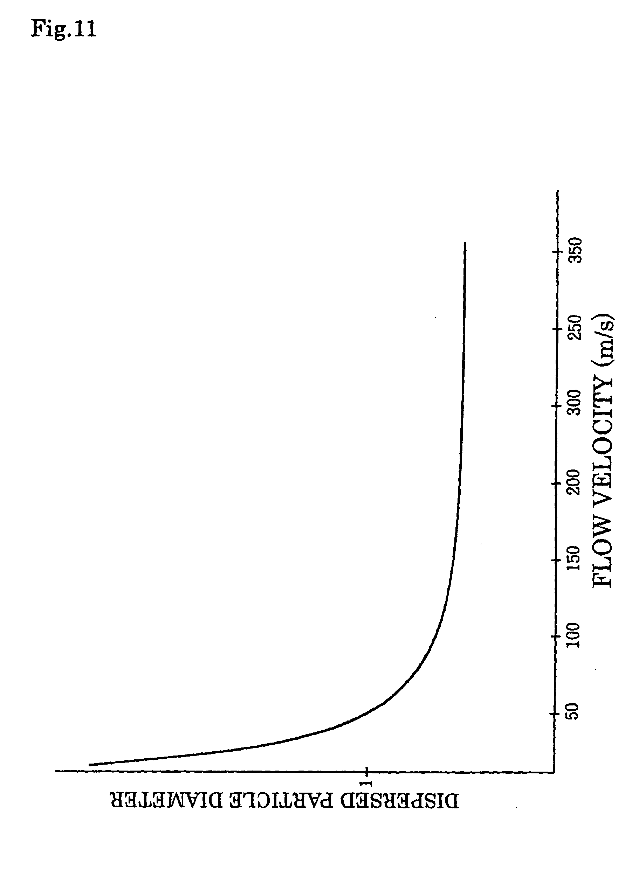

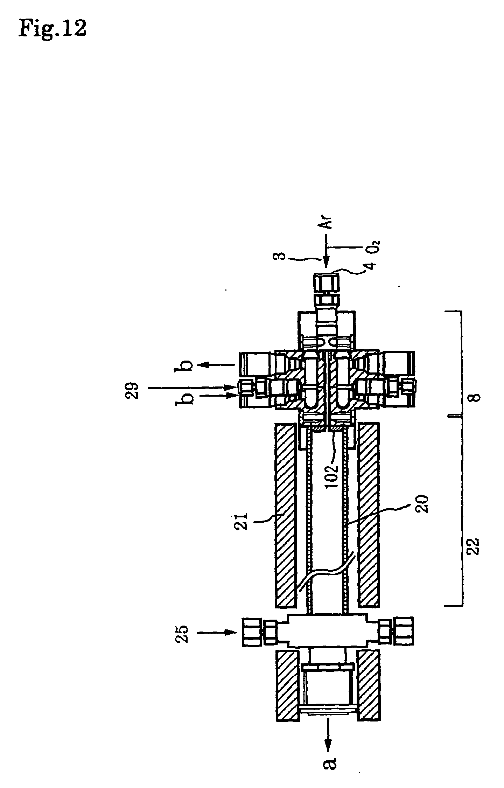

FIG. 11 shows a result as a relative value (example using the apparatus according to the prior art shown in FIG. 12(a) is determined as 1). As seen from FIG. 11, a dispersed particle size becomes small when a flow rate is set to 50 m/s or above, and the dispersed particle size becomes smaller by setting the flow rate to 100 m/s or above. However, even if the flow rate is set to 200 m/s or above, the dispersed particle size is saturated. Therefore, 100 to 200 m/s is a further preferable range.

### (Embodiment 7)

In this example, a rod having spiral grooves formed thereto was used as the rod.

Any other structure is the same as Embodiment 6.

In Embodiment 6, a concentration of the raw material solution supplied to the groove was high in the extended portion of the groove. That is, Sr(DPM)₂ has a high concentration in the extended portion of the groove 67a, Bi(C₆H₅)₃ has a high concentration in the extended portion of the groove 67b, and Ta(OC₂H₅)₅ has a high concentration in the extended portion of the groove 67c.

In this example, however, in the mixed raw material gas obtained at the end of the spiral groove, each organic metal raw material was uniform in any portion.

### (Embodiment 8)

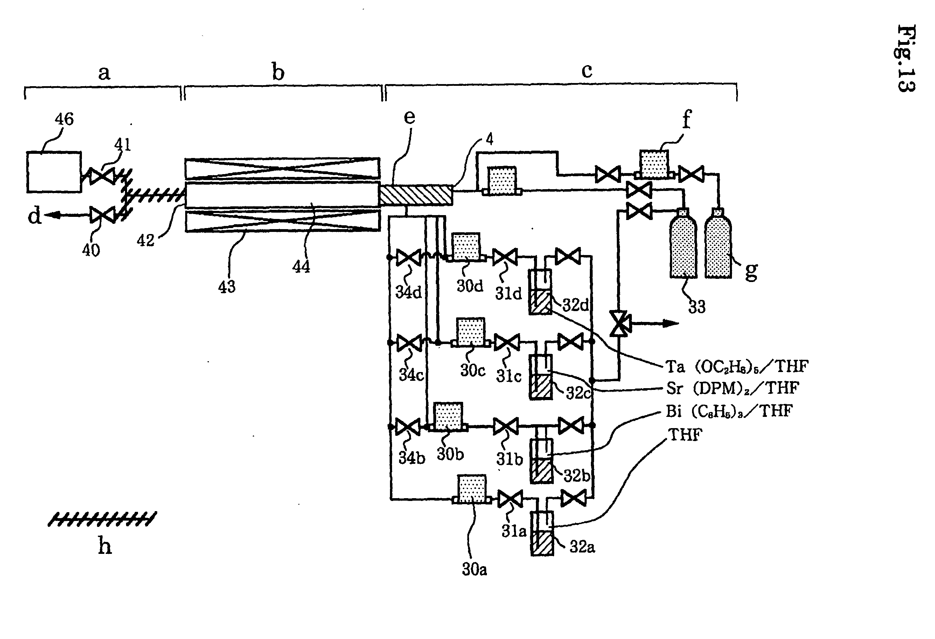

FIGS. 12 and 13 show Embodiment 8.

Introduction of oxygen was conventionally carried out on the downstream side alone of the vaporization portion 22 as shown in FIG. 2. A large quantity of carbon is contained in a film formed by the prior art as described in the background art section. Further, there was a difference between a composition allocation in the raw material and a composition allocation in the formed film. That is, when the raw material was adjusted to have a composition ratio according to the stoichiometry and a film was formed, an actually formed film is a film having a composition deviating from a stoichiometric ratio. In particular, a phenomenon that almost no bismuth is contained (approximately 0.1 at%) was observed.

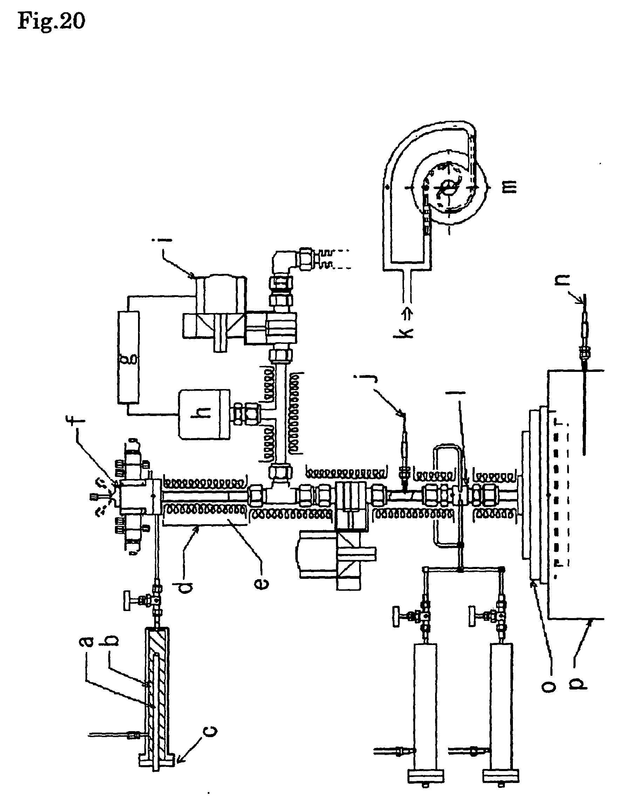

The present inventor discovered that this factor relates to an oxygen introduction position. That is, as shown in FIG. 20, it was found that a difference in composition ratio between a composition in the formed film and a composition in the raw material solution can be made very small by introducing oxygen with the carrier gas from the gas introduction opening 4, a secondary oxygen supply opening 200 near a jet and an oxygen introduction opening (primary oxygen supply opening) 25.

It is to be noted that the carrier gas and oxygen may be mixed with each other in advance and the obtained mixed gas may be introduced from the gas introduction opening 4.

### (Embodiment 9)

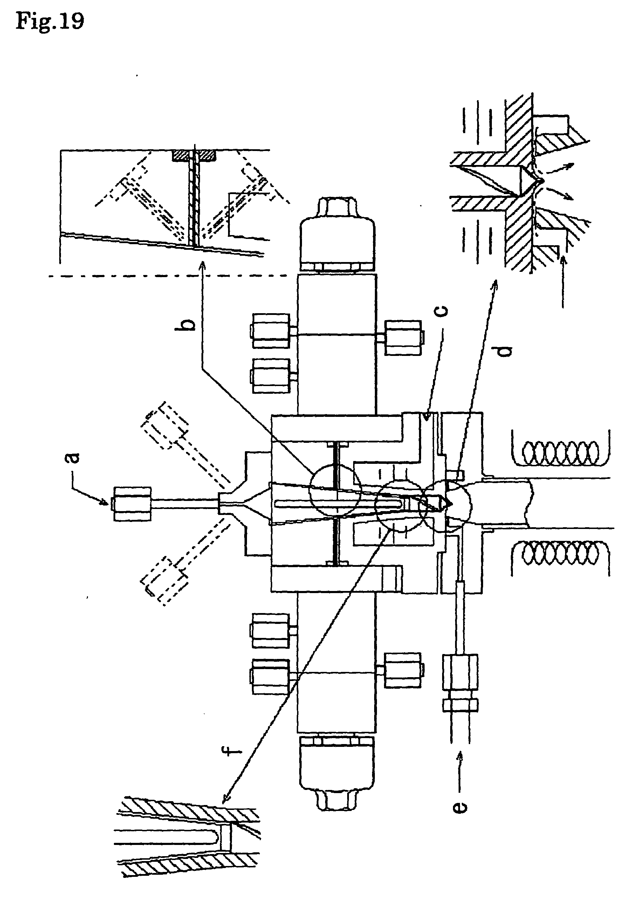

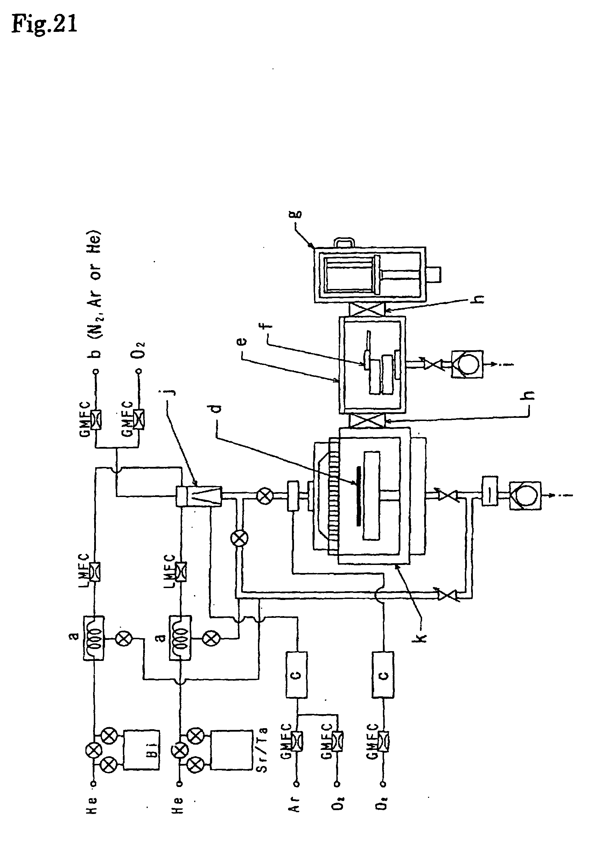

An SBT film was formed by using the vaporizer shown in FIGS. 19 and 20 and the CVD apparatus shown in FIG. 21, and polarization characteristics and others were evaluated.

Specifically, conditions of the vaporizer and conditions of a reaction chamber were controlled in the following manner, and an SBT thin film was formed on a substrate obtained by forming 200 nm of platinum on an oxidized silicon substrate.
Concrete conditions: hexaethoxy strontiumtantalum Sr[Ta(OC₂H₅)₆]₂ 0.1 mol solution (solvent: hexane) 0.02 ml/min.;
tri-t-amyloxide bismuth Bi(O-t-C₅H₁₁)₃ 0.2 mol solution (solvent: hexane) 0.02 ml/min.;
first carrier Ar = 200 sccm (introduced from the gas introduction opening 4);
first carrier O₂ = 10 sccm (introduced from the gas introduction opening 4);
second carrier Ar = 20 sccm (introduced from the gas introduction opening 200);
O₂ = 10 sccm (introduced from the gas introduction opening 200);
reaction oxygen O₂ = 200 sccm (introduced from a lower portion 25 of the dispersion jet portion);
reaction oxygen temperature 216°C (temperature is controlled by an additionally provided heater before introducing from the lower portion of the dispersion jet portion);
wafer temperature 475°C;
spatial temperature 299°C;
spatial distance 30 mm;
shower head temperature 201°C;
reaction pressure 1 Torr; and
film formation time 20 minutes.

### Results

SBT film thickness approximately 300 nm (deposition speed approximately 150 nm/min.)
SBT composition:
Sr 5.4 at%;
Bi 16.4 at%;
Ta 13.1 at%;
O 61.4 at%; and
C 3.5 at%.

A composition ratio difference between the composition in the formed film and the composition in the raw material solution is small, and the deposition speed is approximately fivefold of that in the prior art. It can be understood that the effect of introducing a small quantity of oxygen with the carrier gas from the gas introduction opening 4 is very large. A carbon content is also as small as 3.5 at%.

Since reaction oxygen 200 cc/min was subjected to the accurate temperature control (216°C) by using the additionally provided heater before being introduced from the lower portion of the dispersion jet portion, it was confirmed that the effect of suppressing recondensation/sublimation (solidification) of the vaporized organic metal compound is large from a fact that contaminations in a lower portion of the vaporization tube are eliminated.

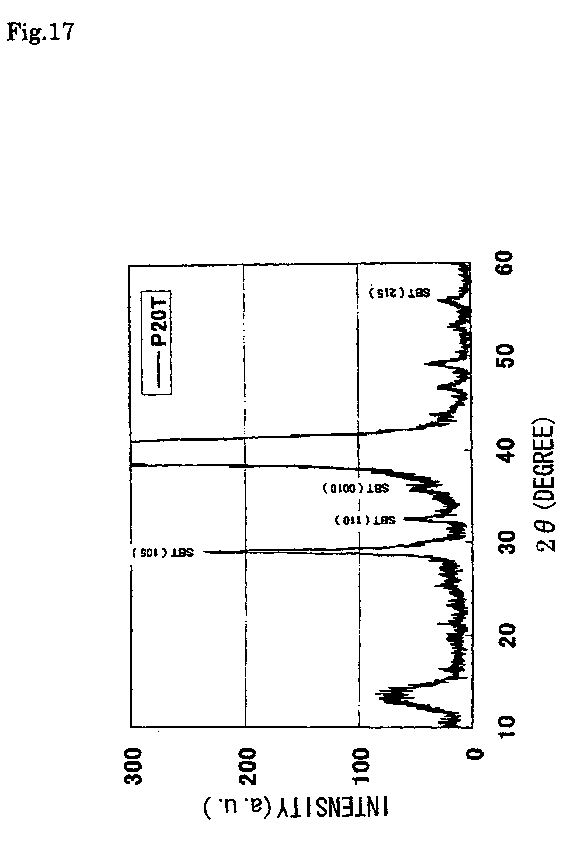

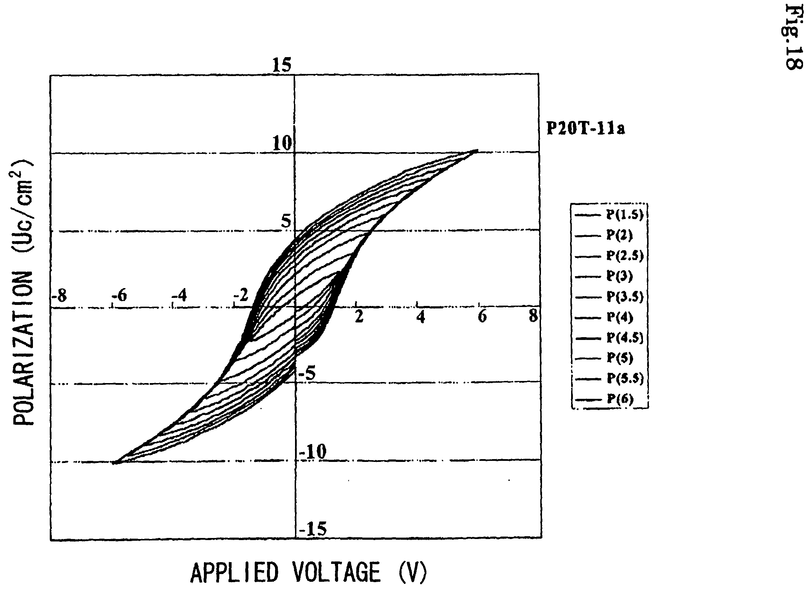

After formation of this SBT thin film, crystallization processing was performed in an oxygen atmosphere at 750°C for 30 minutes, an upper electrode was formed and subjected to measurement/evaluation. It demonstrated excellent crystallization characteristics and polarization characteristics. These characteristics are shown in FIGS. 17 and 18.

By just introducing an oxidative gas such as oxygen from the gas introduction opening 4 or the primary oxygen supply opening provided in close proximity to the jet, introducing oxygen on the downstream side of the vaporization portion and appropriately controlling a quantity of oxygen at the same time are preferable for reducing a composition ratio difference and decreasing a carbon content.

A content of carbon in the formed film can be reduced to 5% to 20% of that in the prior art.

An embodiment of the SBT thin film deposition process will now be described with reference to FIG. 20.

The valve 2 is opened, the valve 1 is closed, a high vacuum is formed in the reaction chamber, and a wafer is moved to the reaction chamber from the load lock chamber after a few minutes.

At this time, in the vaporizer flow the following gases:
hexaethoxy strontiumtantalum Sr[Ta(OC₂H₅)₆]₂ 0.1 mol solution (solvent: hexane) 0.02 ml/min.;
tri-t-amyloxide bismuth Bi(O-t-C₅H₁₁)₃ 0.2 mol solution (solvent: hexane) 0.02 ml/min.;
first carrier Ar = 200 sccm (introduced from the gas introduction opening 4); and
first carrier O₂ = 10 sccm (introduced from the gas introduction opening 4).
They are led to the vacuum pump through the valve 2 and a pressure automatic adjustment valve.

At this time, a pressure gauge is controlled to 4 Torr by the pressure automatic adjustment valve.

After a few minutes from movement of the wafer, when a temperature is stabilized, the valve 1 is opened, the valve 2 is closed, the following gases are passed to the reaction chamber, and deposition is started.
Hexaethoxy strontiumtantalum Sr[Ta(OC₂H₅)₆]₂ 0.1 mol solution (solvent: hexane) 0.02 ml/min.
Tri-t-amyloxide bismuth Bi(O-t-C₅H₁₁)₃ 0.2 mol solution (solvent: hexane) 0.02 ml/min.
First carrier Ar = 200 sccm (introduced from the gas introduction opening 4)
First carrier O₂ = 10 sccm (introduced from the gas introduction opening 4)
Second carrier Ar = 20 sccm (introduced from the gas introduction opening 200)
O₂ = 10 sccm (introduced from the gas introduction opening 200)
Reaction oxygen O₂ = 200 sccm (introduced from a lower portion 25 of the dispersion jet portion)
Reaction oxygen temperature 216°C (temperature is controlled by an additionally provided heater before introducing from the lower portion of the dispersion jet portion)

### Wafer temperature 475°C

A reaction pressure chamber pressure is controlled to 1 Torr (by a non-described pressure automatic adjustment valve).

When a predetermined time (20 minutes in this example) elapses, the valve 2 is opened, and the valve 1 is closed, thereby terminating deposition.

A high vacuum is formed in the reaction chamber to completely remove the reaction gas, and the wafer is taken out to the load lock chamber after one minute.
Capacitor Structure
Pt (200 nm)/CVDSBT (300 nm)/Pt (175 nm)/Ti (30 nm)/SiO₂/Si
Capacitor Manufacturing Process
Lower electrode forming Pt (175 nm)/TI (30 nm) CVDSBT film formation (300 nm)
SBT film crystallization processing (diffusion furnace annealing: Wafer 750°C, 30 min, O₂ atmosphere)
Upper electrode forming Pt (200 nm)
Annealing: 650°C, 02, 30 min

Since the reaction oxygen (example: 200 sccm) is set in the vaporization tube in a room temperature state in the prior art, the organic metal gas is cooled and attached to/deposited on the vaporization tube.

When performing a temperature control of the reaction oxygen supplied from the lower portion of the vaporization portion, a heater is conventionally wound around the outside of a stainless tube (outer shape: 1/4 to 1/16 inch, length: 10 to 100 cm) so that a temperature of an outer wall of the stainless tube can be controlled (e.g., 219°C).

It was considered that a temperature of the outer wall of the stainless tube (e.g., 219°C) = a temperature of oxygen flowing inside (flow quantity 200 sccm).

However, when a temperature of oxygen was measured by using a fine thermocouple, the temperature was increased to only approximately 35°C in the above example.

Thus, an oxygen temperature after heating was directly measured by using a fine thermocouple, and a heater temperature was controlled, thereby accurately controlling the oxygen temperature.

Increasing a temperature of a gas such as oxygen flowing through the tube is not easy, a filler was put in the heating tube to improve the heat exchange efficiency, a temperature of the heated oxygen gas was measured, and a temperature of the heater was adequately controlled.

Means for performing this control is a heat exchanger shown in FIG. 20.

### (Embodiment 10)

FIG. 14 shows Embodiment 10.

Although the foregoing embodiment atomizes each single raw material solution by spraying with a gas and then mixes the atomized raw material solutions, this example is an apparatus which mixes a plurality of raw material solutions and then atomizes the mixed raw material solution.

This example has:
a disperser 150 having formed therein a plurality of solution passages 130a and 130b through which raw material solutions 5a and 5b are supplied, a mixing portion 109 which mixes the plurality of raw material solutions 5a and 5b supplied from the plurality of solution passages 130a and 130b, a supply passage 110 whose one end communicates with the mixing portion 109 and which has an outlet 017 which is on a vaporization portion 22 side, a gas passage 120 which is arranged to spray the mixed raw material solution fed from the mixing portion 109 with a carrier gas or a mixed gas of the carrier gas and oxygen, and cooling means for cooling the inside of the supply passage 110; and
a vaporization portion 22 which has a vaporization tube having one end connected with a reaction tube of an MOCVD apparatus and the other end connected with the outlet 107 of the disperser 150, and heating means 2 for heating the vaporization tube, the vaporization portion 22 heating and vaporizing the gas including the raw material solutions,
wherein a radiant heat prevention material 102 having a pore 101 is arranged on the outer side of the outlet 107.

This example is effective for the raw material solutions which are slow to react even if mixed and, since such solutions are atomized after mixing, a composition becomes accurate as compared with an example in which mixing is performed after atomization. Further, a more accurate composition can be obtained by providing means (not shown) for analyzing a composition of the mixed raw material solution in the mixing portion 109 and controlling supply quantities of the raw material solutions 5a and 5b based on an analysis result.

Furthermore, in this example, since a rod (10 in FIG. 1) does not have to be used, heat propagated through the rod does not heat the inside of the supply passage 110. Moreover, since a cross-sectional area of the supply passage 110 can be reduced and a cross-sectional area of the outlet 107 can be also decreased as compared with an example in which mixing is performed after atomization, the inside of the supply passage 110 is rarely heated by radiation. Therefore, precipitation or the like of a crystal can be reduced without providing the radiation prevention portion 102. However, when precipitation of a crystal should be further prevented, the radiation prevention portion 102 may be provided as shown in FIG. 14.

It is to be noted that the above embodiment shows the example in which the number of the pore is one, but a plurality of such pores may be provided. Moreover, as a diameter of the pore, 2 mm or below is preferable. If the plurality of pores are provided, a smaller diameter can be adopted.

Additionally, in the above-described embodiment, if the carrier flow path and the raw material solution introduction opening form a sharp angle (30 degrees), the solution is pulled by the gas. If this angle is not less than 90 degrees, the solution is pushed by the gas. Therefore, an angle of 30 to 90 degrees is preferable. Specifically, an optimum angle is determined based on the viscosity/flow quantity of the solution. If the viscosity is large or the flow quantity is large, making a sharp angle allows the solution to smoothly flow. Therefore, when embodying the present invention, it is good enough to obtain an optimum angle according to the viscosity/flow quantity from an experiment or the like.

Additionally, in the above-described embodiment, it is preferable to provide a mechanism which controls a distance of a space between a shower head and a susceptor to an arbitrary distance.

Further, it is preferable to provide a liquid massflow controller which controls a flow quantity of the raw material solution and deaerating means for deaeration on the upstream side of the liquid massflow controller. When the raw material solution is introduced to the massflow controller without performing deaeration, irregularities of a formed film is generated on the same wafer or between wafers. By introducing the raw material solution to the massflow controller after deaerating, e.g., helium, the irregularities in the film thickness are considerably reduced.

Provision of means for controlling temperatures of the raw material solution, a helium thrusting container, the liquid massflow container and pipes in the vicinity of these members to fixed temperatures can further prevent irregularities in film thickness. Furthermore, it is possible to avoid a degeneration change in quality of the raw material solution which is chemically unstable. When forming the SBT thin film, a close control is performed in a range of 5°C to 20°C. In particular, a range of 12°C ± 1°C is desirable.

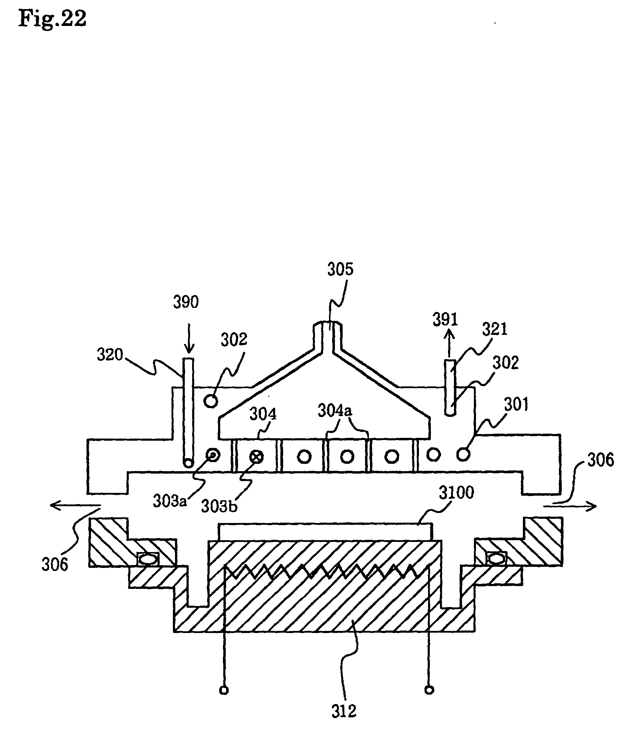

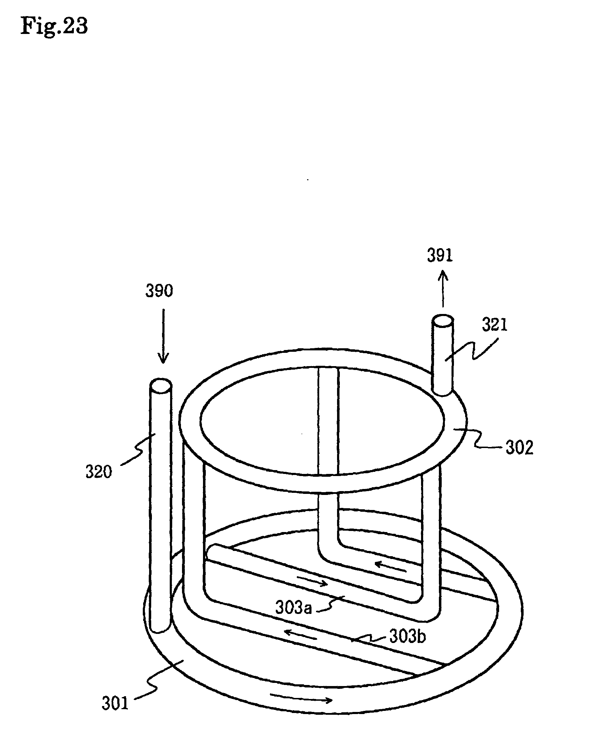

Moreover, as a substrate surface finishing apparatus which sprays a surface of a substrate, e.g., a silicon substrate such as shown in FIGS. 22 and 23 with a predetermined gas and performs surface finishing on the substrate surface, it is preferable to use an apparatus which has an upstream ring 301 connected with a heat transfer medium inlet 320 through which a heat transfer medium flows, a downstream ring 302 connected with a heat transfer medium outlet 321 for the predetermined heat transfer medium, and at least two heat transfer passages 303a and 303b which are connected between the upstream ring 1 and the downstream ring 2 in parallel with each other and form a flow path of the heat transfer medium, wherein directions of flow paths from the upstream ring 1 to the downstream ring 302 between the adjacent heat transfer passages 303a and 303b are alternate and a heat transfer circulation path which obtains a predetermined temperature of the gas is constituted.

Moreover, it is preferable for the substrate surface finishing apparatus to have a thermal conversion plate 304 which is thermally connected with the heat transfer medium circulation path in a plane on which the flow path of the heat transfer medium is formed in the parallel direction which is a predetermined plane in the heat transfer medium circulation path, so that the plane of the thermal conversion plate 304 can be heated to a substantially even temperature by using the heat transfer medium.

Additionally, a plurality of air holes through which the predetermined gas is passed in a direction vertical to the plane are formed on the plane of the thermal conversion plate 304 so that the predetermined gas passing through the air holes can be heated to a substantially even temperature in the plane.

As a result, the directions of the flow paths from the upstream ring to the downstream ring between the adjacent heat transfer passages of the heat transfer medium circulation path are constituted to be alternate. Therefore, temperature differences of areas adjacent to the heat transfer passages are configured to be high/low/high/low .... With this structure, the thermal conversion plate can be evenly heated or cooled. Further, a thermal conversion plate thermally connected with the heat transfer medium circulation path is provided in the plane on which the flow path of the heat transfer medium is formed in the parallel direction. Therefore, the plane of this thermal conversion plate can be further heated to a substantially even temperature.

### (Embodiment 11)

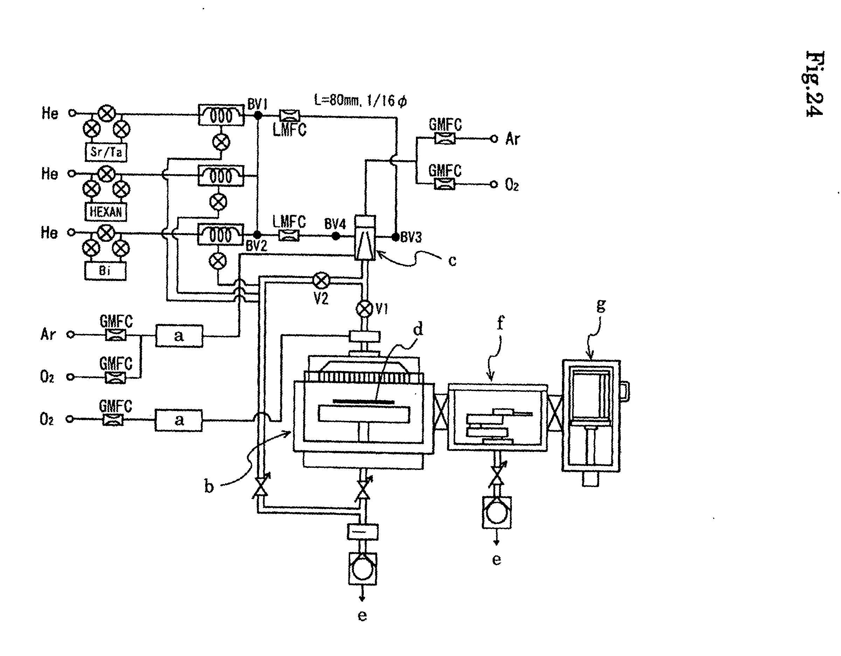

An improvement example of the SBT thin film deposition process will now be described with reference to FIG. 24.

A valve 206V2 is opened, a valve 208V1 is closed, a reaction chamber (process chamber) is caused to form a high vacuum, and a wafer is moved into the reaction chamber 203 from a load lock chamber 204 after one minute.

At this time, the following materials flow through a vaporizer (vaporization chamber) 205.
Hexaethoxy strontiumtantalum Sr[Ta(OC₂H₅)₆]₂ 0.004 mol solution (solvent: hexane) 0.50 ml/min.
Tri-t-amyloxide bismuth Bi(O-t-C₅H₁₁)₃ 0.008 mol solution (solvent: hexane) 0.50 ml/min.
First carrier Ar = 200 sccm (introduced from the gas introduction opening 4)
First carrier O₂ = 10 sccm (introduced from the gas introduction opening 4)

The raw materials are exhausted to a vacuum pump through the valve 206V2 and a pressure automatic adjustment valve 207.

At this time, a pressure gauge is controlled to 4 Torr by the pressure automatic adjustment valve.

When the wafer is moved and a temperature is stabilized after four minutes, the valve 208V1 is opened, the valve 206V2 is closed, the following gases are passed to the reaction chamber 203, thereby starting deposition. Hexaethoxy strontiumtantalum Sr[Ta(OC₂H₅)₆]₂ 0.004 mol solution (solvent: hexane) 0.50 ml/min.
Tri-t-amyloxide bismuth Bi(O-t-C₅H₁₁)₃ 0.2 mol solution (solvent: hexane) 0.50 ml/min.
First carrier Ar = 200 sccm (introduced from the gas introduction opening 4)
First carrier O₂ = 10 sccm (introduced from the gas introduction opening 4)
Second carrier Ar = 20 sccm (introduced from the gas introduction opening 200)
O₂ = 10 sccm (introduced from the gas introduction opening 200)
Reaction oxygen O₂ = 200 sccm (introduced from a lower portion 25 of the dispersion jet portion)
Reaction oxygen temperature 216°C (temperature is controlled by an additionally provided heater before introducing from the lower portion of the dispersion jet portion)
Wafer temperature 475°C
A pressure in the reaction pressure chamber is controlled to 1 Torr (by a non-illustrated pressure automatic adjustment valve).

When a predetermined time (e.g., 20 minutes in this example) elapses, the valve 206V2 is opened, and the valve 208V1 is closed, thereby terminating deposition.

An SBT thin film having a thickness of approximately 200 nm was deposited.

A high vacuum is formed in the reaction chamber 203 to completely remove the reaction gas, and the wafer is taken out to the load lock chamber 204 after one minute. Then, a new wafer is set, and the valve 206V is closed whilst the valve 208V1 is opened after four minutes, thereby starting deposition.

Although there is a time of approximately five minutes after termination of deposition and before start of deposition of the next wafer, cleaning of the vaporizer 205 is carried out in this period. High-purity hexane is passed to MAC of a 0.004 mol solution (solvent: hexane) of hexaethoxy strontiumtantalum Sr[Ta(OC₂H₅)₆]₂ and a 0.008 mol solution (solvent: hexane) of tri-t-amyloxide bismuth Bi(O-t-C₅H₁₁)₃ immediately after termination of deposition.

A total flow quantity is 1.0/min, and a time is three minutes.

When three minutes elapses, the raw materials are switched to a 0.004 mol solution (solvent: hexane) of hexaethoxy strontiumtantalum Sr[Ta(OC₂H₅)₆]₂ and a 0.008 mol solution (solvent: hexane) of tri-t-amyloxide bismuth Bi(O-t-C₅H₁₁)₃.

After two minutes from switching, deposition of the SBT thin film is again started.

Since a pipe arrangement capacity is 1.2 cc, cleaning of the vaporizer was performed by the above-described operation. When the vaporizer was disassembled and inspected after repeating this operation for 20 times, the vaporizer, especially an atomization nozzle portion has no contamination.

### (Embodiment 12)

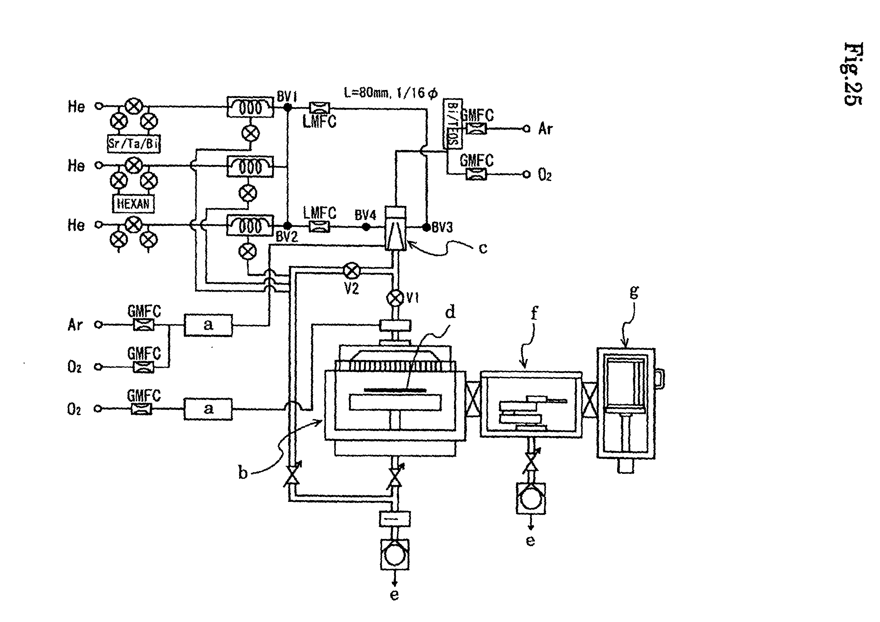

An improvement example of the SBT thin film deposition process will now be described with reference to FIG. 25.

The valve 206V2 is opened, the valve 208V1 is closed, a high vacuum is formed in the reaction chamber 203, and a wafer is moved into the reaction chamber 203 from the load lock chamber 204 after one minute.

At this time, the following raw materials flow through the vaporizer.
Hexaethoxy strontiumtantalum Sr[Ta(OC₂H₅)₆]₂ 0.004 mol solution (solvent: hexane) 0.50 ml/min.
Tri-t-amyloxide bismuth Bi(O-t-C₅H₁₁)₃ 0.008 mol solution (solvent: hexane) 0.60 ml/min.
First carrier Ar = 200 sccm (introduced from the gas introduction opening 4)
First carrier O₂ = 10 sccm (introduced from the gas introduction opening 4)
They are drawn toward the vacuum pump through the valve 206V2 and the pressure automatic adjustment valve 207.

At this time, the pressure gauge is controlled to 4 Torr by the pressure automatic adjustment valve. The wafer is moved and a temperature is stabilized after four minutes, the valve 208V1 is opened, the valve 206V2 is closed, and the following gases are passed to the reaction chamber 203 to start deposition.
Hexaethoxy strontiumtantalum Sr[Ta(OC₂H₅)₆]₂ 0.004 mol solution (solvent: hexane) 0.50 ml/min.
Tri-t-amyloxide bismuth Bi(O-t-C₅H₁₁)₃ 0.2 mol solution (solvent: hexane) 0.60 ml/min.
First carrier Ar = 200 sccm (introduced from the gas introduction opening 4)
First carrier O₂ = 10 sccm (introduced from the gas introduction opening 4)
Second carrier Ar = 20 sccm (introduced from the gas introduction opening 200)
O₂ = 10 sccm (introduced from the gas introduction opening 200)
Reaction oxygen O₂ = 200 sccm (introduced from a lower portion 25 of the dispersion jet portion),
Reaction oxygen temperature 216°C (temperature is controlled by an additionally provided heater before introducing from the lower portion of the dispersion jet portion)
Wafer temperature 475°C.
A pressure in the reaction pressure chamber is controlled to 1 Torr (by a non-illustrated pressure automatic adjustment valve).

When one minute elapses, the valve 206V2 is opened and the valve 208V1 is closed, thereby terminating deposition.

Flow quantities are then changed.
Hexaethoxy strontiumtantalum Sr[Ta(OC₂H₅)₆]₂ 0.004 mol solution (solvent: hexane) 0.50 ml/min.
Tri-t-amyloxide bismuth Bi(O-t-C₅H₁₁)₃ 0.2 mol solution (solvent: hexane) 0.50 ml/min.

After one minute, the valve 208V1 is opened and the valve 206V2 is closed in order to restart deposition. After seven minutes elapse, the valve 206V2 is opened and the valve 208V1 is closed, thereby terminating deposition.

An SBT thin film having a thickness of approximately 80 nm was deposited.

A high vacuum is formed in the reaction chamber 203 to completely remove the reaction gas, and the wafer is taken out to the load lock chamber 205 after one minute. A new wafer is then set, and the valve 206V2 is closed whilst the valve 208V1 is opened after four minutes, thereby starting deposition.

### Industrial Applicability

1. Although droplets adhere to an end of the vaporizer and a five-hour operation causes clogging in the prior art, the present invention can provide a vaporizer for a film formation apparatus for MOCVD or the like or any other apparatus which can be used for a long time without producing clogging and stably supply raw materials to a reaction portion.
2. A composition of a CVD thin film can be changed/controlled in a thickness direction.
3. A reduction in cost can be achieved.
4. A reduction in deposition speed and deposition rate can be eliminated.

## Claims

1. A CVD thin film deposition method which forms a predetermined CVD thin film by passing a CVD raw material solution and a gas to a CVD chamber for an appropriate time through a vaporizer, wherein the gas from a vaporizer outlet is switched to an exhaust side and only a solvent which can dissolve attachments adhering to the vaporizer (which will be referred to as a "cleaning solvent" hereinafter) is caused to flow through the vaporizer when the predetermined time passed.

2. The CVD thin film deposition method according to claim 1, wherein the cleaning solvent is a solvent of a CVD raw material.

3. The CVD thin film deposition method according to claim 1, wherein the cleaning solvent is one or more of hexane, benzene, toluene, octane and decane.

4. The CVD thin film deposition method according to any of claims 1 to 3, wherein a pipe arrangement capacity from a CVD raw material solution switching valve to the vaporizer is not more than 8 Xcc when a flow quantity of the cleaning solvent is determined as (Xcc/min.).

5. The CVD thin film deposition method according to any of claims 1 to 4, wherein a pipe arrangement capacity from the CVD raw material solution switching valve to the vaporizer is not more than 2 Xcc when a flow quantity of the cleaning solvent is determined as (Xcc/min.).

6. The CVD thin film deposition method according to any of claims 1 to 5, wherein a pipe arrangement capacity from the CVD raw material solution switching valve to the vaporizer is not more than Xcc when a flow quantity of the cleaning solvent is determined as (Xcc/min.).

7. A CVD thin film deposition method which forms a predetermined CVD thin film by passing a CVD raw material solution and a gas to a CVD chamber for an appropriate time through a vaporizer, wherein the gas from a vaporizer outlet is switched to an exhaust side and only a solvent which can dissolve attachments adhering to the vaporizer is caused to flow through the vaporizer to clean the vaporizer when the predetermined time passed, and
an operation of taking out a substrate on which a predetermined thin film is formed and setting a new substrate in the CVD chamber is performed in the CVD chamber simultaneously with the cleaning.

8. A CVD thin film deposition method which forms a predetermined CVD thin film by passing a CVD raw material solution and a gas to a CVD chamber for an appropriate time through a vaporizer,
wherein the gas from a vaporizer outlet is switched to an exhaust side in order to interrupt deposition of a thin film and a type and a flow quantity of the CVD raw material solution are changed to those of a new CVD raw material solution when the predetermined time passed, and
the new CVD raw material solution and the gas are passed to the CVD chamber through the vaporizer for an appropriate time and deposition of a thin film is restarted in order to form two types of CVD thin films having different compositions when a sum (capacity) of flow quantities of the new CVD raw material solution exceeds onefold or twofold of a pipe arrangement capacity from a CVD raw material solution switching valve to the vaporizer.

9. A CVD thin film deposition method which forms a predetermined CVD thin film by passing a CVD raw material solution and a gas to a CVD chamber for an appropriate time through a vaporizer,
wherein the CVD thin film deposition method continuously forms two or more types of CVD thin films by repeating:
a first operation of switching the gas from a vaporizer outlet to an exhaust side in order to interrupt deposition of a thin film and changing a type and a flow quantity of the CVD raw material solution to those of a new CVD raw material solution when the predetermined time passed; and
a second operation of passing the new CVD raw material solution and the gas to the CVD chamber through the vaporizer for an appropriate time and restarting deposition of a thin film in order to form a second CVD thin film having a different composition when a sum (capacity) of flow quantities of the new CVD raw material solution exceeds onefold or twofold of a pipe arrangement capacity from a CVD raw material solution switching valve to the vaporizer.

10. A CVD thin film deposition method which forms a predetermined CVD thin film by passing a CVD raw material solution and a gas to a CVD chamber for an appropriate time through a vaporizer,
wherein the gas from a vaporizer outlet is switched to an exhaust side in order to interrupt deposition of a thin film, a type and a flow quantity of the CVD raw material solution are changed to those of a new CVD raw material solution and a substrate temperature/reaction pressure is changed when the predetermined time passed, and
two or more types of CVD thin films are continuously formed by repeating a second operation of passing the new CVD raw material solution and the gas to the CVD chamber through the vaporizer for an appropriate time and restarting deposition of a thin film in order to form a second CVD thin film having a different composition when a sum (capacity) of flow quantities of the new CVD raw material solution exceeds onefold or twofold of a pipe arrangement capacity from a CVD raw material solution switching valve to the vaporizer.

11. The CVD thin film deposition method according to any of claims 1 to 10, wherein the vaporizer comprises:
(1) a dispersion portion having
a gas passage formed therein,
a gas introduction opening from which a carrier gas is introduced to the gas passage,
means for supplying a raw material solution to the gas passage,
a gas outlet from which the carrier gas including the raw material solution is supplied to a vaporization portion, and
means for cooling the gas passage; and
(2) a vaporization portion having
a vaporization tube having one end connected to a reaction portion of an apparatus for film formation or of any other type and the other end connected to the gas outlet, and
heating means for heating the vaporization tube,
the vaporization portion heating the carrier gas which is supplied from the dispersion portion and includes the atomized raw material solution and vaporizing the carrier gas,
the vaporizer having a radiation prevention portion which has a pore provided on the outer side of the gas outlet.

12. The CVD thin film deposition method according to any of claims 1 to 10, wherein the vaporizer comprises:
(1) a dispersion portion having
a gas passage formed therein,
a gas introduction opening from which a carrier gas is introduced to the gas passage,
means for supplying a raw material solution to the gas passage, and
a gas outlet from which the carrier gas including the raw material solution is supplied to a vaporization portion; and
(2) a vaporization portion having
a vaporization tube having one end connected to a reaction portion of an apparatus for film formation or of any other type and the other end connected to the gas outlet, and
heating means for heating the vaporization tube,
the vaporization portion heating the carrier gas which is supplied from the dispersion portion and includes the raw material solution and vaporizing the carrier gas,
(3) the dispersion portion having a dispersion portion main body which has a cylindrical or conical hollow portion, and a rod which has an outside diameter smaller than an inside diameter of the cylindrical or conical hollow portion,
the rod having one or more spiral grooves at the periphery thereof on the vaporizer side, and being inserted into the cylindrical or conical hollow portion, the inside diameter of the rod expanding in a tapered form toward the vaporizer side in some cases,
(4) a radiation prevention portion which has a pore on the gas outlet side and whose inside diameter expands in a tapered form toward the vaporizer side being provided on the outer side of the gas outlet.

13. The CVD thin film deposition method according to any of claims 1 to 10, wherein the vaporizer comprises:
(1) a dispersion portion having
a gas passage formed therein,
a gas introduction opening from which a carrier gas is introduced to the gas passage,
means for supplying a raw material solution to the gas passage,
a gas outlet from which the carrier gas including the raw material solution is supplied to a vaporization portion, and
means for cooling the gas passage; and
(2) a vaporization portion having:
a vaporization tube having one end connected to a reaction portion of an apparatus for film formation or of any other type and the other end connected to the gas outlet, and
heating means for heating the vaporization tube,
the vaporization portion heating the carrier gas which is supplied from the dispersion portion and includes the raw material solution and vaporizing the carrier gas,
the vaporizer being able to add an oxidative gas to the carrier gas from the gas introduction opening or introduce the oxidative gas from a primary oxygen supply opening.

14. The CVD thin film deposition method according to any of claims 1 to 10, wherein the vaporizer comprises:
(1) a dispersion portion having
a gas passage formed therein,
a gas introduction opening from which a carrier gas is introduced to the gas passage,
means for supplying a raw material solution to the gas passage,
a gas outlet from which the carrier gas including the raw material solution is supplied to a vaporization portion, and
means for cooling the gas passage; and
(2) a vaporization portion having
a vaporization tube having one end connected to a reaction portion of an apparatus for film formation or of any other type and the other end connected to the gas outlet, and
heating means for heating the vaporization tube,
the vaporization portion heating the carrier gas which is supplied from the dispersion portion and includes the raw material solution and vaporizing the carrier gas,
a radiation prevention portion which has a pore being provided on the outer side of the gas outlet,
the vaporizer being able to introduce the carrier gas and an oxidative gas from the gas introduction opening.

15. The CVD thin film deposition method according to any of claims 1 to 10, wherein the vaporizer comprises:
a disperser having formed thereto,
a plurality of solution passages through which raw material solutions are supplied,
a mixing portion which mixes the plurality of raw material solutions supplied from the plurality of solution passages,
a supply passage whose one end communicates with the mixing portion and which has an outlet which is on the vaporization side,
a gas passage which is arranged to spray a mixed raw material solution exiting from the mixing portion with the carrier gas or a mixed gas obtained from the carrier gas and oxygen in the supply passage, and
cooling means for cooling the gas passage; and
a vaporization portion having
a vaporization tube having one end connected to a reaction portion of an apparatus for film formation or of any other type and the other end connected to an outlet of the disperser, and
heating means for heating the vaporization tube,
the vaporization portion heating the carrier gas which is supplied from the dispersion portion and includes the raw material solutions and vaporizing the carrier gas,
a radiation prevention portion which has a pore being provided on the outer side of the gas outlet,
a primary oxygen supply opening from which an oxidative gas can be introduced being provided in close proximity to the dispersion jet portion.

16. The CVD thin film deposition method according to any of claims 1 to 15, wherein a vaporization method in the vaporizer is a vaporization method which shears/atomizes the raw material solution to obtain a raw material mist by introducing the raw material solution in the gas passage and injecting the carrier gas toward the introduced raw material solution, and then supplies the raw material mist to the vaporization portion in order to vaporize this mist, and this method is a vaporization method which has oxygen contained in the carrier gas.
